# EUROPEAN PATENT APPLICATION

(11) **EP 4 486 094 A1**
(43) Date of publication of application: **01.01.2025**
(21) Application number: 24184931.4
(22) Date of filing: 27.06.2024
(51) Int. Cl.: H10K 59/131, G09G 3/3233

(54) **DISPLAY DEVICE**

(30) Priority: 27.06.2023 KR 20230082442
(71) Applicant: Samsung Display Co., Ltd., Yongin-si, Gyeonggi-do 17113 (KR)
(72) Inventor: PARK, Do Yeong, Yongin-si (KR); KIM, Kyung Bae, Yongin-si (KR); LEE, Yong Hee, Yongin-si (KR)
(74) Representative: Marks & Clerk LLP

(57) **Abstract**

The present disclosure relates to a display device capable of increasing the capacitance of a capacitor and improving image quality. The display device may include a first data line, a first pixel connected to the first data line, and including a driving transistor, and a first capacitor between a gate electrode of the driving transistor and the first data line.

## Description

### BACKGROUND

### 1. Field

The present disclosure relates to a display device for increasing the capacitance of a capacitor, and for improving image quality.

### 2. Description of the Related Art

An organic light-emitting display device includes a display element of which luminance is changed by current, for example, an organic light-emitting diode.

### SUMMARY

Aspects of the present disclosure provide a display device for increasing the capacitance of a capacitor and for improving image quality.

The aspects of the present disclosure are not limited to those mentioned above and additional aspects of the present disclosure, which are not mentioned herein, will be clearly understood by those skilled in the art from the following description of the present disclosure.

According to one or more embodiments of the disclosure, a display device includes a first data line, a first pixel connected to the first data line, and including a driving transistor, and a first capacitor between a gate electrode of the driving transistor and the first data line.

The first capacitor may overlap the first data line and the gate electrode.

The display device may further include a second data line adjacent to the first data line, and a second pixel connected to the second data line.

The first capacitor may be between the first data line and the gate electrode, and between the second data line and the gate electrode.

The second data line may be more distant from the gate electrode than the first data line.

The first pixel and the second pixel may be between the first data line and the second data line.

The first pixel and the second pixel may be configured to provide light of a same color.

The first capacitor may include a first capacitor electrode including electrodes spaced apart from each other to have a gap, an insulating layer above the first capacitor electrode, and a second capacitor electrode above the insulating layer, and overlapping the gap and the electrodes of the first capacitor electrode.

At least a part of the second capacitor electrode may be between adjacent electrodes.

The second capacitor electrode may overlap an entirety of the first capacitor electrode.

An end of the second capacitor electrode may extend further in one direction than an end of the first capacitor electrode.

The first capacitor may include a first insulating layer including layers having stepped portions of different respective sizes, a first capacitor electrode above the first insulating layer, and having stepped portions corresponding to the stepped portions of the first insulating layer, a second insulating layer above the first capacitor electrode, and having stepped portions corresponding to the stepped portions of the first capacitor electrode, and a second capacitor electrode above the second insulating layer, and having stepped portions corresponding to the stepped portions of the second insulating layer.

The first capacitor electrode may have a larger number of layers than the first insulating layer.

The first capacitor electrode may include a first electrode extending in a first direction, and second electrodes extending from the first electrode in a second direction crossing the first direction, adjacent ones of the second electrodes being spaced apart such that a gap exists therebetween.

The first capacitor electrode may include a first electrode having a closed curve shape, and second electrodes inside the first electrode in plan view, and extending in one direction from the first electrode, adjacent ones of the second electrodes being spaced apart such that a gap exists therebetween.

The first capacitor electrode may include a first electrode having a closed curve shape, and second electrodes inside the first electrode in plan view, and respectively extending from the first electrode in a first direction and a second direction, wherein the second electrodes in the first direction and the second electrodes in the second direction substantially perpendicularly intersect each other, and wherein adjacent ones of the second electrodes are spaced apart such that a gap exists therebetween.

The first capacitor electrode may include a first electrode having a closed curve shape, and second electrodes inside the first electrode in plan view, and respectively extending in a first oblique direction and in a second oblique direction from the first electrode, wherein the second electrodes in the first oblique direction and the second electrodes in the second oblique direction substantially perpendicularly intersect each other, and wherein adjacent ones of the second electrodes are spaced apart such that a gap exists therebetween.

The first capacitor electrode may include first electrodes and second electrodes having a spiral structure extending outwardly while rotating in a counterclockwise direction from a central portion, wherein adjacent ones of the first electrodes are spaced apart such that a gap exists therebetween, and wherein adjacent ones of the second electrodes are spaced apart such that a gap exists therebetween.

The display device may further include a second capacitor above the first capacitor.

The second capacitor may be at a same layer as the first data line.

The second capacitor may include a first capacitor electrode, and a second capacitor electrode adjacent to the first capacitor electrode, and at a same layer as the first capacitor electrode.

The first capacitor may include a first capacitor electrode and a second capacitor electrode opposite each other on different layers, wherein a taper angle of the first capacitor electrode in the first capacitor is smaller than a taper angle of the first capacitor electrode in the second capacitor.

The display device may further include a first connection electrode connected to the first capacitor electrode, a second connection electrode above the first connection electrode, and a third connection electrode connecting the first connection electrode to the second connection electrode, and between the first connection electrode and the second connection electrode.

According to one or more embodiments of the disclosure, a display device includes a substrate, a transistor above the substrate, a first data line above the transistor, and a capacitor between a gate electrode of the transistor and the first data line.

The capacitor may overlap the first data line and the gate electrode.

The display device may further include a second data line adjacent to the first data line.

The capacitor may be between the first data line and the gate electrode, and between the second data line and the gate electrode.

The second data line may be more distant from the gate electrode than the first data line.

The capacitor may include a first capacitor electrode including electrodes spaced apart to have a gap therebetween, an insulating layer above the first capacitor electrode, and a second capacitor electrode above the insulating layer to overlap the gap and the electrodes of the first capacitor electrode.

At least a part of the second capacitor electrode may be between adjacent ones of the electrodes.

In accordance with the display device according to one or more embodiments of the present disclosure, at least a part of a second capacitor electrode is located in the gap of a first capacitor electrode, so that surface areas of facing surfaces between the first capacitor electrode and the second capacitor electrode may be increased. Therefore, the capacitance of the capacitor may be increased.

Further, in accordance with the display device according to one or more embodiments of the present disclosure, the capacitor is located between the gate electrode of a transistor and a data line, so that the capacitance of a coupling capacitor between the gate electrode and the data line may be reduced or minimized. Therefore, crosstalk may be reduced, and image quality may be improved.

It should be noted that the aspects of the present disclosure are not limited to those described above, and other aspects not mentioned will be clearly understood by those skilled in the art from the description below.

At least some of the above and other features of the invention are set out in the claims.

### BRIEF DESCRIPTION OF THE DRAWINGS

The above and other aspects of the present disclosure will become more apparent by describing in detail embodiments thereof with reference to the attached drawings, in which:
FIG. 1 is a cross-sectional view of a display device according to one or more embodiments;
FIG. 2 is a three-dimensional view showing some metal layers and insulating layers included in the transistor layer of FIG. 1;
FIG. 3 is a view showing only the metal layers in FIG. 2;
FIG. 4 is a cross-sectional view of a display device according to one or more embodiments that is taken along the line I-I' of FIG. 2;
FIG. 5 is a cross-sectional view of a display device according to one or more embodiments;
FIG. 6 is a plan view of the first capacitor electrode of the display device according to one or more embodiments;
FIG. 7 is a plan view of the first capacitor electrode of the display device according to one or more embodiments;
FIG. 8 is a plan view of the first capacitor electrode of the display device according to one or more embodiments;
FIG. 9 is a plan view of the first capacitor electrode of the display device according to one or more embodiments;
FIG. 10 is a diagram showing arrangement of pixels of a display device according to one or more embodiments;
FIG. 11 is a circuit configuration diagram of the first pixel shown in FIG. 10;
FIG. 12 is a cross-sectional view of a display device according to one or more embodiments;
FIG. 13 is a plan view of one or more embodiments of a first-second capacitor of FIG. 12;
FIG. 14 is a cross-sectional view of a display device according to one or more embodiments;
FIG. 15 is a cross-sectional view of a display device according to one or more embodiments;
FIG. 16 is a cross-sectional view of a display device according to one or more embodiments;
FIG. 17 is an enlarged view of part A of FIG. 14;
FIG. 18 is an enlarged view of part B of FIG. 14; and
FIG. 19 is a diagram illustrating effects of a display device according to one or more embodiments.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

In the drawings, the relative sizes of elements, layers, and regions may be exaggerated for clarity and/or descriptive purposes. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to" may be construed similarly. It will be understood that when an element or layer is referred to as being "between" two elements or layers, it can be the only element or layer between the two elements or layers, or one or more intervening elements or layers may also be present.

For the purposes of this disclosure, expressions, such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expression, such as "at least one of A and B" and "at least one of A or B" may include A, B, or A and B. As used herein, "or" generally means "and/or," and the term "and/or" includes any and all combinations of one or more of the associated listed items. For example, the expression, such as "A and/or B" may include A, B, or A and B. Similarly, expressions, such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

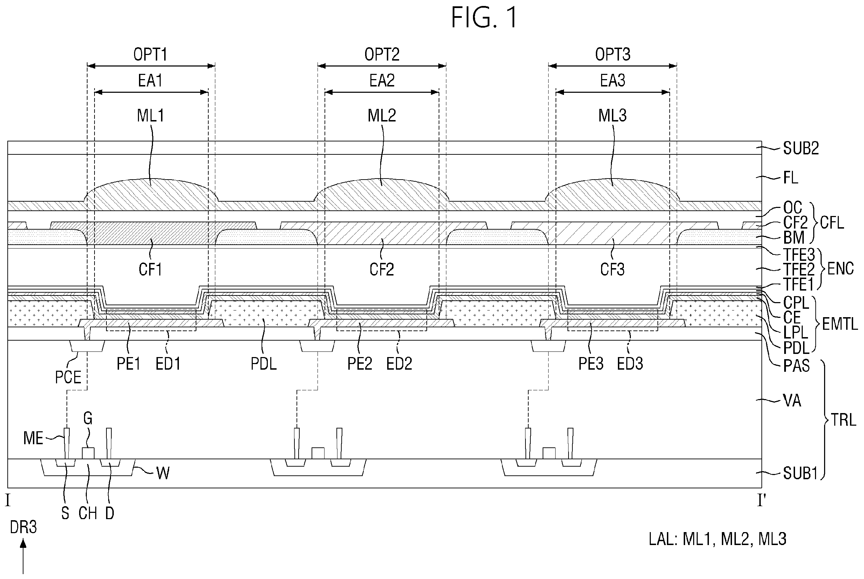

FIG. 1 is a cross-sectional view of a display device according to one or more embodiments.

As shown in FIG. 1, the display device may include a base substrate SUB1, a transistor layer TRL, a light-emitting element layer EMTL, an encapsulation layer ENC, a color filter layer CFL, a lens array layer LAL, and an encapsulation substrate SUB2.

The base substrate SUB1 may be a silicon substrate, a germanium substrate, or a silicon-germanium substrate. The base substrate SUB1 may be a substrate doped with first type impurities.

A well region W may be located on the base substrate SUB1 (or in the base substrate SUB1). The well region W may be a region doped with second type impurities. The second type impurity may be different from the aforementioned first type impurity. For example, when the first type impurity is a p-type impurity, the second type impurity may be an n-type impurity. Meanwhile, when the first type impurity is an n-type impurity, the second type impurity may be a p-type impurity.

A source region S, a drain region D, and a channel region CH of a transistor TR may be located in the well region W. For example, the source region S (or source electrode) and the drain region D (or drain electrode) of the transistor TR may be located in the well region W. Each of the source region S and the drain region D may be a region doped with the aforementioned first type impurities. The gate electrode G of the transistor TR may intersect and overlap the well region W. In plan view, the well region W intersecting the gate electrode G may be defined as two parts, and the source region S may be located in any one of the two parts, and the drain region D may be located in the other part thereof. In other words, in the well region W, the source region S and the drain region D may be located on respective sides of the gate electrode G with the gate electrode G interposed therebetween. The channel region CH of the transistor may be located in the region of the well region W that overlaps the gate electrode G.

Meanwhile, the source region S may include a first low-concentration impurity region having an impurity concentration that is relatively lower than those of other portions of the source region S. In other words, a portion of the source region S may include a lower concentration of impurities than other portions of the source region S. The drain region D may include a second low-concentration impurity region having an impurity concentration that is relatively lower than those of other portions of the drain region D. In other words, a portion of the drain region D may include a lower concentration of impurities than other portions of the drain region D.

The first low-concentration impurity region and the second low-concentration impurity region may be located close to the channel region CH of the transistor TR. For example, the first low-concentration impurity region may be located relatively close to the channel region CH to overlap a first spacer located on one side of the gate electrode G, and the second low-concentration impurity region may be located relatively close to the channel region CH to overlap a second spacer located on the other side of the gate electrode G. In this way, the distance between the high-concentration impurity region of the source region S and the high-concentration impurity region of the drain region D may be increased due to the first low-concentration impurity region and the second low-concentration impurity region, and the length of the channel region CH may be increased due to the increase in the distance. Accordingly, the likelihood of punch-through and hot carrier phenomena caused by a short channel may be reduced or prevented.

An interlayer insulating layer VA may be located on the base substrate SUB1.

A passivation layer PAS may be located on the interlayer insulating layer VA.

The light-emitting element layer EMTL may be located on the passivation layer PAS. The light-emitting element layer EMTL may include, for example, a first light-emitting element ED1, a second light-emitting element ED2, and a third light-emitting element ED3 located in different respective emission areas. For example, the first light-emitting element ED1 of the light-emitting element layer EMTL may be located in a first emission area EA1, the second light-emitting element ED2 of the light-emitting element layer EMTL may be located in a second emission area EA2, and the third light-emitting element ED3 of the light-emitting element layer EMTL may be located in a third emission area EA3.

Each of the first light-emitting element ED1, the second light-emitting element ED2, and the third light-emitting element ED3 may provide white light.

The first light-emitting element ED1 may include a first pixel electrode PE1 (or first anode electrode), a light-providing layer LPL, and a common electrode CE stacked in a third direction DR3.

The second light-emitting element ED2 may include a second pixel electrode PE2 (or second anode electrode), the light-providing layer LPL, and the common electrode CE stacked in the third direction DR3.

The third light-emitting element ED3 may include a third pixel electrode PE3 (or third anode electrode), the light-providing layer LPL, and the common electrode CE stacked in the third direction DR3.

Here, the light-providing layer LPL and the common electrode CE may be common layers commonly used by the light-emitting elements ED1 to ED3. In other words, the plurality of light-emitting elements ED1 to ED3 of the light-emitting element layer EMTL may share the light-providing layer LPL and the common electrode CE.

The light-providing layer LPL may include a plurality of light-emitting layers for providing lights of different respective colors, and the plurality of light-emitting layers may be stacked along the third direction DR3. Different lights from the plurality of light-emitting layers may be mixed to generate white light. Meanwhile, the light-providing layer LPL may further include a charge generation layer.

The first pixel electrode PE1, the second pixel electrode PE2, and the third pixel electrode PE3 may be respectively connected to each source region S of each transistor TR through a pixel connection electrode PCE and a metal connection layer ME.

The first pixel electrode PE1 may correspond to the first emission area EA1, the second pixel electrode PE2 may correspond to the second emission area EA2, and the third pixel electrode PE3 may correspond to the third emission area EA3.

A bank PDL (or pixel-defining layer) may be located on the first pixel electrode PE1, the second pixel electrode PE2, and the third pixel electrode PE3. The bank PDL may define the emission areas of the pixels (for example, the first emission area EA1 of the first pixel, the second emission area EA2 of the second pixel, and the third emission area EA3 of the third pixel). To this end, the bank PDL may expose a partial region of each of the first pixel electrode PE1, the second pixel electrode PE2, and the third pixel electrode PE3 on the passivation layer PAS. The bank PDL may cover the edge of each of the first pixel electrode PE1, the second pixel electrode PE2, and the third pixel electrode PE3. The bank PDL may be formed of an organic layer, such as acryl resin, epoxy resin, phenolic resin, polyamide resin, polyimide resin, and the like.

The light-providing layer LPL may be located on the pixel electrodes PE1, PE2, and PE3 and the bank PDL. For example, the light-providing layer LPL may be located on the first pixel electrode PE1, the second pixel electrode PE2, the third pixel electrode PE3, and the bank PDL. The light-providing layer LPL may include a plurality of light-emitting units. For example, the light-providing layer LPL may include a first light-emitting unit, a second light-emitting unit, and a third light-emitting unit stacked in the third direction DR3. The light-emitting units may provide lights of different respective wavelengths. For example, the first light-emitting unit, the second light-emitting unit, and the third light-emitting unit may emit lights of different respective colors. For example, the light-providing layer LPL may have a tandem structure in which the plurality of light-emitting units providing lights of different colors are stacked in a vertical direction (for example, the third direction DR3).

The first light-emitting unit may be located on the pixel electrodes PE1, PE2, and PE3. The first light-emitting unit may include a first light-emitting layer, a hole-transporting layer, an organic material layer, and an electron-transporting layer.

A second light-emitting unit may be located on the first light-emitting unit. The second light-emitting unit may include a second light-emitting layer, a hole-transporting layer, an organic material layer, and an electron-transporting layer.

A third light-emitting unit may be located on the second light-emitting unit. The third light-emitting unit may include a third light-emitting layer, a hole-transporting layer, an organic material layer, and an electron-transporting layer.

The light-emitting elements ED1, ED2, and ED3 may provide white light by mixing light of a first color (for example, blue) from the first light-emitting unit, light of a second color (for example, red) from the second light-emitting unit, and light of a third color (for example, green) from the third light-emitting unit. For example, each of the first light-emitting element ED1, the second light-emitting element ED2, and the third light-emitting element ED3 may provide white light.

Further, the light-providing layer LPL may further include at least one charge generation layer in addition to the aforementioned light-emitting units. The charge generation layer may be located between the light-emitting units adjacent in the third direction DR3, for example. The charge generation layer may include a first charge generation layer and a second charge generation layer stacked in the third direction DR3, for example. In this case, the first charge generation layer may be located between the first light-emitting unit and the second light-emitting unit, and the second charge generation layer may be located between the second light-emitting unit and the third light-emitting unit.

On the other hand, each charge generation layer may include a negative charge generation layer and a positive charge generation layer. For example, the first charge generation layer may include a first negative charge generation layer and a first positive charge generation layer stacked in the third direction DR3, and the second charge generation layer may include a second negative charge generation layer and a second positive charge generation layer stacked in the third direction DR3.

The common electrode CE may be located on the light-providing layer LPL. For example, the common electrode CE may be located on the light-providing layer LPL to overlap the first pixel electrode PE1, the second pixel electrode PE2, the third pixel electrode PE3, the first emission area EA1, the second emission area EA2, the third emission area EA3, and the bank PDL. In the top emission structure, the common electrode CE may be formed of a transparent conductive material (TCO), such as ITO or IZO, that is capable of transmitting light, or may be formed of a semi-transmissive conductive material, such as magnesium (Mg), silver (Ag), or an alloy of magnesium (Mg) and/or silver (Ag). When the common electrode CE is formed of a semi-transmissive conductive material, the light emission efficiency can be increased due to a micro-cavity effect.

A capping layer CPL may be located on the common electrode CE. The capping layer CPL may include an inorganic insulating material. In one or more embodiments, the capping layer CPL may include aluminum oxide, titanium oxide, tantalum oxide, hafnium oxide, zinc oxide, silicon oxide, silicon nitride, and/or silicon oxynitride.

The encapsulation layer ENC may be located on the capping layer CPL. The encapsulation layer ENC may cover the top surface and the side surface of the light-emitting element layer EMTL, and may protect the light-emitting element layer EMTL. The encapsulation layer ENC may include at least one inorganic layer, and at least one organic layer for encapsulating the light-emitting element layer EMTL. The encapsulation layer ENC may include at least one inorganic layer TFE1 and/or TFE3 to reduce or prevent oxygen or moisture from permeating into the light-emitting element layer EMTL. In addition, the encapsulation layer ENC may include at least one organic layer to protect the light-emitting element layer EMTL from foreign substances, such as dust. For example, the encapsulation layer ENC may include a first inorganic encapsulation layer TFE1, an organic encapsulation layer TFE2, and a second inorganic encapsulation layer TFE3.

The first inorganic encapsulation layer TFE1 may be located on the capping layer CPL, the organic encapsulation layer TFE2 may be located on the first inorganic encapsulation layer TFE1, and the second inorganic encapsulation layer TFE3 may be located on the organic encapsulation layer TFE2. The first inorganic encapsulation layer TFE1 and the second inorganic encapsulation layer TFE3 may be formed of a multilayer in which one or more inorganic layers of a silicon nitride layer, a silicon oxynitride layer, a silicon oxide layer, a titanium oxide layer, and/or an aluminum oxide layer are alternately stacked. The encapsulation organic layer TFE2 may be an organic layer, such as acryl resin, epoxy resin, phenolic resin, polyamide resin, polyimide resin or the like.

A light-blocking layer BM may be located on the encapsulation layer ENC. The light-blocking layer BM may include a plurality of holes OPT1, OPT2, and OPT3 respectively overlapping the emission areas EA1, EA2, and EA3. For example, the first hole OPT1 may overlap the first emission area EA1, the second hole OPT2 may overlap the second emission area EA2, and the third hole OPT3 may overlap the third emission area EA3. The areas or sizes of the holes OPT1, OPT2, and OPT3 may be larger than the areas or sizes of the emission areas EA1, EA2, and EA3 defined by the bank PDL, respectively. The holes OPT1, OPT2, and OPT3 of the light-blocking layer BM are formed to be larger than the emission areas EA1, EA2, and EA3, so that the light emitted from the emission areas EA1, EA2, and EA3 may be visually recognized by the user not only from the front surface but also from the side surface of the display device 10.

The light-blocking layer BM may include a light-absorbing material. For example, the light-blocking layer BM may include an inorganic black pigment or an organic black pigment. The inorganic black pigment may be carbon black, and the organic black pigment may include at least one of lactam black, perylene black, or aniline black, but they are not limited thereto. The light-blocking layer BM may reduce or prevent visible light infiltration and color mixture between the first to third emission areas EA1, EA2, and EA3, which leads to the improvement of color reproducibility of the display device 10.

Further, the display device 10 may include a plurality of color filters CF1, CF2, and CF3 located on the emission areas EA1, EA2, and EA3. The plurality of color filters CF1, CF2, and CF3 may correspond to the emission areas EA1, EA2, and EA3, respectively. For example, the color filters CF1, CF2, and CF3 may be located on the light-blocking layer BM including the plurality of holes OPT1, OPT2, and OPT3 corresponding to the emission areas EA1, EA2, and EA3, respectively.

The color filters CF1, CF2, and CF3 may include a first color filter CF1, a second color filter CF2, and a third color filter CF3 corresponding to the different emission areas EA1, EA2, and EA3, respectively. The color filters CF1, CF2, and CF3 may include a colorant, such as a dye or a pigment that absorbs light in a wavelength band other than light in a corresponding wavelength band, and may correspond to the color of the light emitted from the emission areas EA1, EA2, and EA3. For example, the first color filter CF1 may be a red color filter that overlaps the first emission area EA1 and transmits only the first light of the red color. The second color filter CF2 may be a green color filter that overlaps the second emission area EA2 and transmits only the second light of the green color, and the third color filter CF3 may be a blue color filter that overlaps the third emission area EA3 and transmits only the third light of the blue color.

The plurality of color filters CF1, CF2, and CF3 may be spaced apart from other adjacent color filters CF1, CF2, and CF3 on the light-blocking layer BM. The color filters CF1, CF2, and CF3 may have areas that are larger than those of the holes OPT1, OPT2, and OPT3 of the light-blocking layer BM, respectively, while covering the holes. The color filters CF1, CF2, and CF3 may have areas that are sufficient to be spaced apart from other color filters CF1, CF2, and CF3 on the light-blocking layer BM. However, the present disclosure is not limited thereto. The plurality of color filters CF1, CF2, and CF3 may partially overlap other adjacent color filters CF1, CF2, and CF3. The different color filters CF1, CF2, and CF3 are areas that do not overlap the emission areas EA1, EA2, and EA3, and may overlap each other on the light-blocking layer BM. In the display device, the color filters CF1, CF2, and CF3 may overlap each other, so that the intensity of the reflected light by external light may be reduced. Furthermore, the color of the reflected light by the external light may be controlled by adjusting the disposition, shape, and area of the color filters CF1, CF2, and CF3 in plan view.

An overcoat layer OC may be located on the color filters CF1, CF2, and CF3 to planarize the top ends of the color filters CF1, CF2, and CF3. The overcoat layer OC may be a colorless light transmissive layer that does not have a color in a visible light band. For example, the overcoat layer OC may include a colorless light transmissive organic material, such as an acrylic resin.

The lens array layer LAL may be located on the overcoat layer OC. The lens array layer LAL may include a plurality of micro lenses ML1, ML2, and ML3. For example, the lens array layer LAL may include a first micro lens ML1 corresponding to the first emission area EA1 or a first hole OPT1, a second micro lens ML2 corresponding to the second emission area EA2 or a second hole OPT2, and a third micro lens ML3 corresponding to the third emission area EA3 or a third hole OPT3.

The micro lenses ML1, ML2, and ML3 may have sizes that are larger than those of the corresponding holes OPT1, OPT2, and OPT3. For example, the micro lenses ML1, ML2, and ML3 may respectively completely cover the corresponding holes OPT1, OPT2, and OPT3, and may overlap a part of the light-blocking layer BM. Because the micro lenses ML1, ML2, and ML3 are formed to be larger than the holes OPT1, OPT2, and OPT3 of the light-blocking layer BM, lights emitted from the emission areas EA1, EA2, and EA3 may be recognized by a user from the side surface as well as the front surface of the display device 10.

A filler FL may be located on the lens array layer LAL. The filler FL may be located between adjacent micro lenses.

The encapsulation substrate SUB2 may be located on the filler FL.

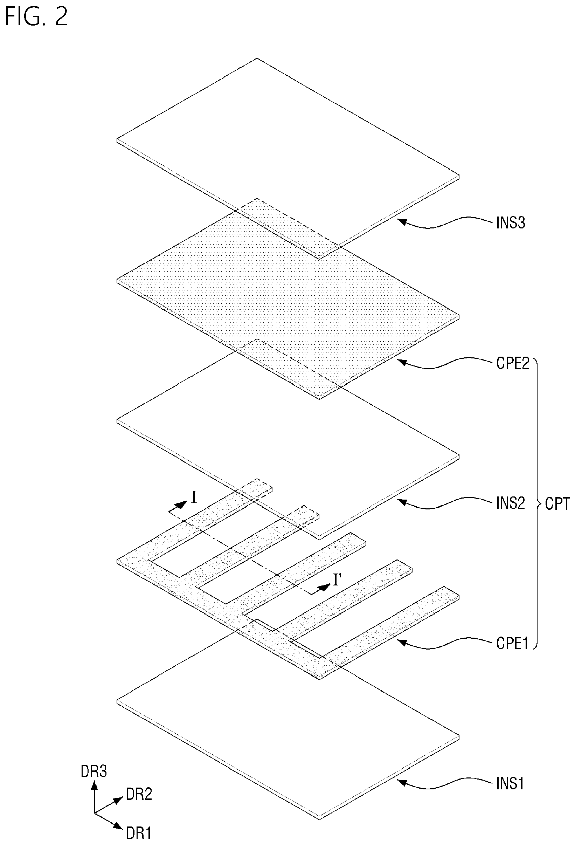

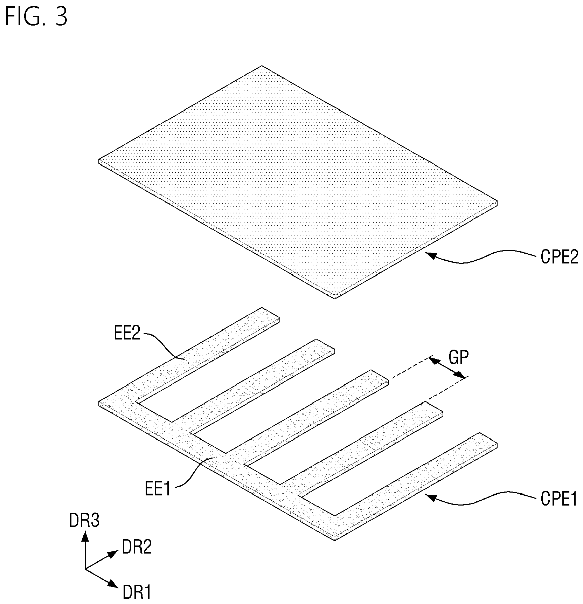

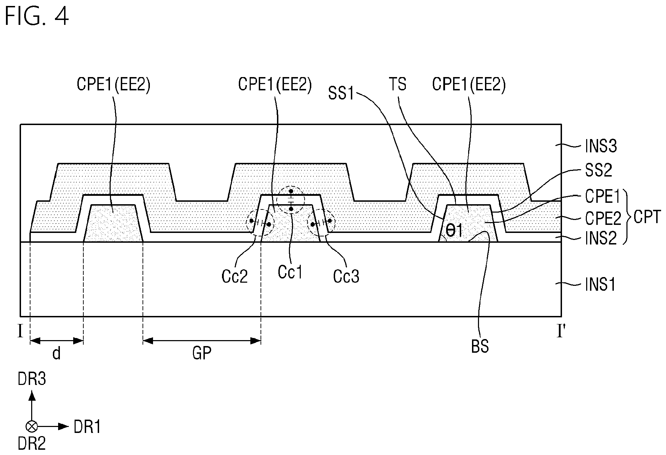

FIG. 2 is a three-dimensional view showing some metal layers and insulating layers included in the transistor layer TRL of FIG. 1, FIG. 3 is a view showing only the metal layers in FIG. 2, and FIG. 4 is a cross-sectional view of a display device according to one or more embodiments that is taken along the line I-I' of FIG. 2.

As shown in FIGS. 2 to 4, the transistor layer TRL of the display device may include a first insulating layer INS1, a first capacitor electrode CPE1, a second insulating layer INS2, a second capacitor electrode CPE2, and a third insulating layer INS3 that are sequentially located (or stacked) along the third direction DR3. Here, a capacitor CPT may include a first capacitor electrode, a second insulating layer, and a second capacitor electrode. In this case, the first capacitor electrode CPE1 and the second capacitor electrode CPE2 may be the first electrode and the second electrode of the capacitor CPT, respectively.

The transistor layer TRL may include a plurality of insulating layers located along the third direction DR3. For example, the interlayer insulating layer of the transistor layer TRL may include a plurality of insulating layers located along the third direction DR3, and FIGS. 2 and 3 illustrate the first insulating layer INS1, the second insulating layer INS2, and the third insulating layer INS3 among the plurality of insulating layers.

Further, the transistor layer TRL may include a plurality of metal layers located along the third direction DR3, and each metal layer may be located between adjacent insulating layers. FIGS. 2 and 3 illustrate metal layers including the first capacitor electrode CPE1 and the second capacitor electrode CPE2 among the plurality of metal layers. Here, the first capacitor electrode CPE1 may be located between the first insulating layer INS1 and the second insulating layer INS2, and the second capacitor electrode CPE2 may be located between the second insulating layer INS2 and the third insulating layer INS3.

The first insulating layer INS1 may be, for example, a layer containing silicon oxide (SiOx).

The first capacitor electrode CPE1 may be located on the first insulating layer INS1. As in the example shown in FIGS. 2 and 3, the first capacitor electrode CPE1 may include a first electrode EE1 and a plurality of second electrodes EE2.

The first electrode EE1 may extend along a first direction DR1. The first electrode EE1 may have a rectangular shape.

The plurality of second electrodes EE2 may extend from the first electrode EE1 along a second direction DR2. The plurality of second electrodes EE2 may be arranged along the first direction DR1. The second electrodes EE2 may be spaced apart from each other at equal intervals. Accordingly, a gap GP may be formed between adjacent second electrodes. Each second electrode EE2 may have a rectangular shape. The plurality of second electrodes EE2 may be integrally formed with the first electrode EE1.

As shown in FIG. 4, an angle θ1 (for example, a tapered angle), which is formed by a bottom surface BS and a first side surface SS1 of the first capacitor electrode CPE1, may be an acute angle. The angle formed by the bottom surface BS and a second side surface SS2 of the first capacitor electrode CPE1 may also be an acute angle. The angle θ1 formed by the bottom surface BS and the first side surface SS1 of the first capacitor electrode CPE1 may be equal to the angle formed by the bottom surface BS and the second side surface SS2 of the first capacitor electrode CPE1.

The second insulating layer INS2 may be located on the first capacitor electrode CPE1. As shown in FIG. 4, the second insulating layer INS2 may be located on a top surface TS and the side surfaces SS1 and SS2 of the first capacitor electrode CPE1. Further, as shown in FIG. 4, the second insulating layer INS2 may be located between adjacent second electrodes EE2 of the first capacitor electrode CPE1. The second insulating layer INS2 located between the second electrodes EE2 may be located on the first insulating layer INS1 located thereunder. The second insulating layer INS2 located between the second electrodes EE2 may be in contact with the first insulating layer INS1.

The second insulating layer INS2 may be located on the first capacitor electrode CPE1 to overlap the entire first capacitor electrode CPE1.

The first capacitor electrode CPE1 may be surrounded by the second insulating layer INS2 and the first insulating layer INS1. For example, as shown in FIG. 4, the top surface TS and the side surfaces SS1 and SS2 of the first capacitor electrode CPE1 may be covered by the second insulating layer INS2, and the bottom surface BS of the first capacitor electrode CPE1 may be covered by the first insulating layer INS1. In this case, the second insulating layer INS2 may be in contact with the top surface TS and the side surfaces SS1 and SS2 of the first capacitor electrode CPE1, and the first insulating layer INS1 may be in contact with the bottom surface BS of the first capacitor electrode CPE1.

The second insulating layer INS2 may have a stepped portion conforming to the shape of the first capacitor electrode CPE1 located thereunder. For example, the second insulating layer INS2 overlapping (or in contact with) the top surface TS of the first capacitor electrode CPE1 may be located higher than the second insulating layer INS2 overlapping (or in contact with) the first insulating layer INS1. In other words, the second insulating layer INS2 may be higher, or may have a greater height, in the region overlapping the top surface TS of the first capacitor electrode CPE1 than in the region overlapping, or contacting, the first insulating layer INS1 (for example, the region that does not overlap the first capacitor electrode CPE1). Here, the height of the second insulating layer INS2 may correspond to the third direction DR3.

The second insulating layer INS2 may be, for example, a layer including silicon nitride (SiNx).

The second capacitor electrode CPE2 may be located on the second insulating layer INS2. The second capacitor electrode CPE2 may be located on the second insulating layer INS2 to overlap the entire first capacitor electrode CPE1.

As shown in FIG. 4, the second capacitor electrode CPE2 may be located on the second insulating layer INS2 to overlap the top surface TS and the side surfaces SS1 and SS2 of the first capacitor electrode CPE1. Further, as shown in FIG. 4, the second capacitor electrode CPE2 may be located on the second insulating layer INS2 to be positioned between adjacent second electrodes EE2 of the first capacitor electrode CPE1. In other words, at least a part of the second capacitor electrode CPE2 may be located in the gap GP between adjacent second electrodes EE2.

The second capacitor electrode CPE2 may have a stepped portion conforming to the shape of the first insulating layer INS1 located thereunder. For example, the second capacitor electrode CPE2 located on the second insulating layer INS2 to overlap the top surface TS of the first capacitor electrode CPE1 may be located higher than, or may have a height that is greater than, the second capacitor electrode CPE2 located between the second electrodes EE2. In other words, the second capacitor electrode CPE2 may be located higher in the region overlapping the top surface TS of the first capacitor electrode CPE1 than in the region that does not overlap the first capacitor electrode CPE1. Here, the height of the second capacitor electrode CPE2 may correspond to the third direction DR3.

The end of the second capacitor electrode CPE2 and the end of the first capacitor electrode CPE1 may be spaced apart from each other in the first direction

DR1. For example, the end of any one second electrode located at the outermost part among the second electrodes of the first capacitor electrode CPE1, and the end of the first capacitor electrode CPE1 adjacent thereto, may be spaced apart from each other in the first direction DR1. To this end, the end of the second capacitor electrode CPE2 may extend further than the end of the first capacitor electrode CPE1 by a distance d (e.g., a predetermined distance) in the first direction DR1, or in a reverse direction of, or opposite direction to, the first direction DR1 (hereinafter referred to as a first reverse direction).

The third insulating layer INS3 may be located on the second capacitor electrode CPE2. The third insulating layer INS3 may have a planarized top surface regardless of the stepped portions of patterns located thereunder. The third insulating layer INS3 may be, for example, a layer containing silicon oxide.

Because the gap GP exists between the second electrodes EE2 of the first capacitor electrode CPE1, the second capacitor electrode CPE2 may be located in the gap GP. Therefore, the surface areas of the facing surfaces between the first capacitor electrode CPE1 and the second capacitor electrode CPE2 may be increased. Accordingly, the first side surface SS1 and the second side surface SS2 of the first capacitor electrode CPE1, as well as the top surface TS of the first capacitor electrode CPE1, may face the second capacitor electrode CPE2. Therefore, the capacitor CPT formed by the first capacitor electrode CPE1 and the second capacitor electrode CPE2 may have a relatively large capacitance. For example, the aforementioned capacitor CPT may include a first capacitor/capacitance Cc1 between the top surface TS of the first capacitor electrode CPE1 and the second capacitor electrode CPE2, a second capacitor/capacitance Cc2 between the first side surface SS1 of the first capacitor electrode CPE1 and the second capacitor electrode CPE2, and a third capacitor/capacitance Cc3 between the second side surface SS2 of the first capacitor electrode CPE1 and the second capacitor electrode CPE2.

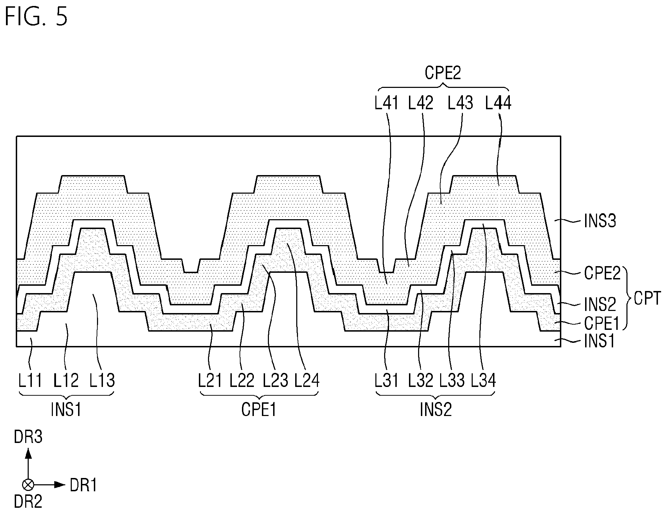

FIG. 5 is a cross-sectional view of a display device according to one or more embodiments.

Referring to FIG. 5, the capacitor CPT of the display device according to one or more embodiments may include the first capacitor electrode CPE1, the second insulating layer INS2, and the second capacitor electrode CPE2. In addition, the display device may further include the first insulating layer INS1 located under the first capacitor electrode CPE1, and the third insulating layer INS3 located above the second capacitor electrode CPE2.

As shown in FIG. 5, the first insulating layer INS1 may include layers L11, L12, and L13 having stepped portions of different sizes (for example, height differences; or thicknesses). For example, the first insulating layer INS1 may include the first layer L11 having a first height (or a first thickness), the second layer L12 having a second height (or a second thickness), and the third layer L13 having a third height (or a third thickness).

The second layer L12 may be located higher than the first layer L11, and the third layer L13 may be located higher than the second layer L12. For example, the top surface (or uppermost surface) of the second layer L12 may be located higher than the top surface (or uppermost surface) of the first layer L11, and the top surface (or uppermost surface) of the third layer L13 may be located higher than the top surface (or uppermost surface) of the second layer L12.

The three layers L11, L12, and L13 of the first insulating layer INS1 that have stepped portions of different sizes may be formed by manufacturing the first insulating layer INS1 using a half-tone mask, for example.

The first capacitor electrode CPE1, the second insulating layer INS2, the second capacitor electrode CPE2, and the third insulating layer INS3 may be sequentially located on the first insulating layer INS1 along the third direction DR3. For example, the first capacitor electrode CPE1 may be located on the first insulating layer INS1, the second insulating layer INS2 may be located on the first capacitor electrode CPE1, the second capacitor electrode CPE2 may be located on the second insulating layer INS2, and the third insulating layer INS3 may be located on the second capacitor electrode CPE2. In this case, because the layers L11, L12, and L13 of the first insulating layer INS1 have the stepped portions of different sizes, the first capacitor electrode CPE1, the second insulating layer INS2, and the second capacitor electrode CPE2 located on the first insulating layer INS1 may have the stepped portions corresponding to the stepped portions of the first insulating layer INS1. Accordingly, the surface areas of the facing surfaces between the first capacitor electrode CPE1 and the second capacitor electrode CPE2 may be further increased. Therefore, the capacitance of the capacitor formed between the first capacitor electrode CPE1 and the second capacitor electrode CPE2 may be further increased.

Meanwhile, as shown in FIG. 5, the first capacitor electrode CPE1 may include a larger number of layers compared to the first insulating layer INS1 located thereunder. For example, the first capacitor electrode CPE1 may include four layers L21, L22, L23, and L24 having stepped portions of different sizes (for example, height differences). For example, the first capacitor electrode CPE1 may include the first layer L21 having a first height, the second layer L22 having a second height, the third layer L23 having a third height, and the fourth layer L24 having a fourth height.

The second layer L22 may be located higher than the first layer L21, the third layer L23 may be located higher than the second layer L22, and the fourth layer L24 may be located higher than the third layer L23. For example, the top surface (or uppermost surface) of the second layer L22 may be located higher than the top surface (or uppermost surface) of the first layer L21, the top surface (or uppermost surface) of the third layer L23 may be located higher than the top surface (or uppermost surface) of the second layer L22, and the top surface (or uppermost surface) of the fourth layer L24 may be located higher than the top surface (or uppermost surface) of the third layer L23.

When the first capacitor electrode CPE1 includes the four layers L21, L22, L23, and L24 having stepped portions of different sizes as described above, the second insulating layer INS2 located on the first capacitor electrode CPE1 may also include four layers L31, L32, L33, and L34 having stepped portions of different sizes. Further, when the second insulating layer INS2 includes the four layers L31, L32, L33, and L34 having stepped portions of different sizes as described above, the second capacitor electrode CPE2 located on the second insulating layer INS2 may also include four layers L41, L42, L43, and L44 having stepped portions of different sizes.

The four layers of the first capacitor electrode CPE1 that have stepped portions of different sizes may be formed by manufacturing the first capacitor electrode CPE1 using a half-tone mask, for example. Meanwhile, when the first capacitor electrode CPE1 is formed using a general mask other than a half-tone mask, the number of layers (for example, three layers L21, L22, and L23) included in the first capacitor electrode CPE1 may be the same as the number of layers included in the first insulating layer INS located thereunder. For example, when the first capacitor electrode CPE1 is formed using a half-tone mask, the first capacitor electrode CPE1 may include a larger number of layers compared to the first insulating layer INS1 located thereunder.

In plan view, each of the first capacitor electrode CPE1 and the second capacitor electrode CPE2 of FIG. 5 may have the same shape as that of the second capacitor electrode CPE2 of FIG. 3 described above.

Meanwhile, the first insulating layer INS1 may include, for example, four or more layers having different heights (or thicknesses). In this case, the first capacitor electrode CPE1, the second insulating layer INS2, and the second capacitor electrode CPE2 that are located above the first insulating layer INS1 may also include four or more layers having different heights.

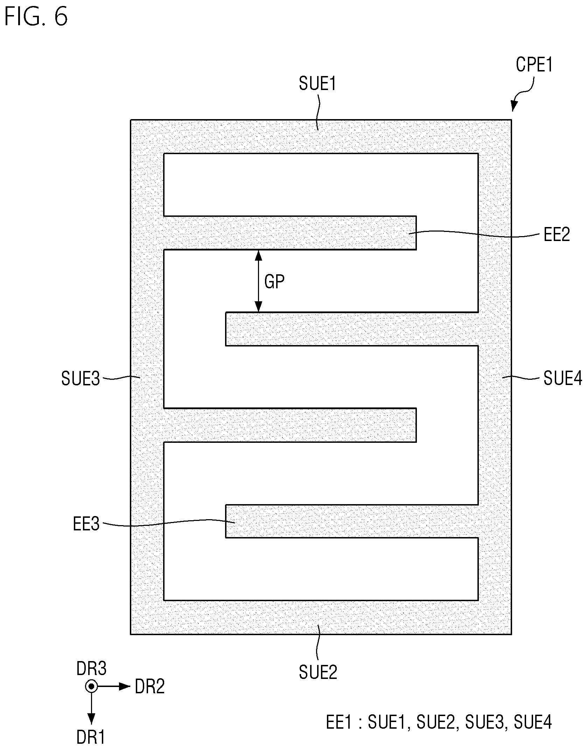

FIG. 6 is a plan view of the first capacitor electrode CPE1 of the display device according to one or more embodiments.

As shown in FIG. 6, the first capacitor electrode CPE1 may include the first electrode EE1, the second electrode EE2, and a third electrode EE3. The first electrode EE1, the second electrode EE2, and the third electrode EE3 may be integrally formed.

The first electrode EE1 may have a closed curve shape or a ring shape. For example, the first electrode EE1 may have a rectangular frame shape that is longer in the first direction DR1 than in the second direction DR2. The first electrode EE1 may include, for example, a first sub-electrode SUE1, a second sub-electrode SUE2, a third sub-electrode SUE3, and a fourth sub-electrode SUE4 connected (e.g., electrically connected) to each other. The first sub-electrode SUE1, the second sub-electrode SUE2, the third sub-electrode SUE3, and the fourth sub-electrode SUE4 may be integrally formed.

Each of the first sub-electrode SUE1 and the second sub-electrode SUE2 may extend along the second direction DR2. The first sub-electrode SUE1 and the second sub-electrode SUE2 may face each other (e.g., may be opposite to each other).

Each of the third sub-electrode SUE3 and the fourth sub-electrode SUE4 may extend along the first direction DR1. The third sub-electrode SUE3 and the fourth sub-electrode SUE4 may face each other (e.g., may be opposite to each other).

The second electrode EE2 may be located in (e.g., may be surrounded by, in plan view) the first electrode EE1. In other words, the second electrode EE2 may be located in the region surrounded by the first electrode EE1. The second electrode EE2 may extend from the inner surface of the first electrode EE1 along the second direction DR2. For example, the second electrode EE2 may extend from the inner surface of the third sub-electrode SUE3 toward the inner surface of the fourth sub-electrode SUE4 along the second direction DR2. The end of the second electrode EE2 may be spaced apart from the inner surface of the fourth sub-electrode SUE4 at a regular interval. A plurality of second electrodes EE2 may be provided. FIG. 6 shows, for one example, that two second electrodes EE2 are spaced apart from each other in the first electrode EE1. However, the present disclosure is not limited thereto, and three or more second electrodes EE2 may be spaced apart from each other in the first electrode EE1.

The third electrode EE3 may be located in (e.g., may be surrounded by, in plan view) the first electrode EE1. In other words, the third electrode EE3 may be located in the region surrounded by the first electrode EE1. The third electrode EE3 may extend from the inner surface of the first electrode EE1 in a reverse direction of, or opposite direction to, the second direction DR2 (hereinafter referred to as a second reverse direction). For example, the third electrode EE3 may extend from the inner surface of the fourth sub-electrode SUE4 toward the inner surface of the third sub-electrode SUE3 along the second reverse direction. The end of the third electrode EE3 may be spaced apart from the inner surface of the third sub-electrode SUE3 at a regular interval. A plurality of third electrodes may be provided. FIG. 6 shows, for one example, that two third electrodes EE3 are spaced apart from each other in the first electrode EE1. However, the present disclosure is not limited thereto, and three or more third electrodes EE3 may be spaced apart from each other in the first electrode EE1.

The plurality of second electrodes EE2 and the plurality of third electrodes EE3 described above may be alternately located in the first electrode EE1. The second electrode EE2 and the third electrode EE3 may have the same length. Here, the length of the second electrode EE2 (or the third electrode EE3) may be measured along the second direction DR2.

The second electrode EE2 and the third electrode EE3 may be located in parallel (e.g., may be located to be substantially parallel).

The distance between the second electrodes EE2 adjacent to each other may be the same as the distance between the third electrodes EE3 adjacent to each other.

The gap GP may exist between the second electrode EE2 and the third electrode EE3 adjacent to each other.

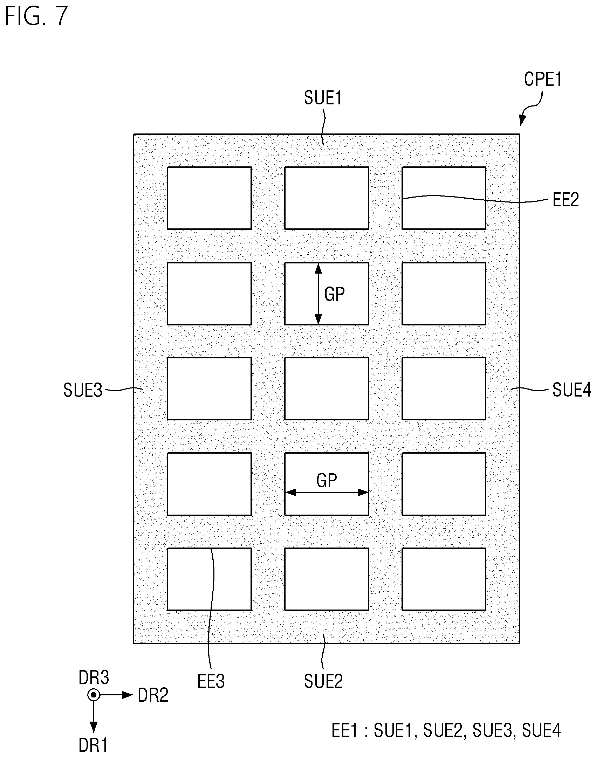

FIG. 7 is a plan view of the first capacitor electrode CPE1 of the display device according to one or more embodiments.

As shown in FIG. 7, the first capacitor electrode CPE1 may include the first electrode EE1, the second electrode EE2, and a third electrode EE3. The first electrode EE1, the second electrode EE2, and the third electrode EE3 may be integrally formed.

The first electrode EE1 may have a closed curve shape or a ring shape. For example, the first electrode EE1 may have a rectangular frame shape that is longer in the first direction DR1 than in the second direction DR2. The first electrode EE1 may include, for example, a first sub-electrode SUE1, a second sub-electrode SUE2, a third sub-electrode SUE3, and a fourth sub-electrode SUE4 connected to each other. The first sub-electrode SUE1, the second sub-electrode SUE2, the third sub-electrode SUE3, and the fourth sub-electrode SUE4 may be integrally formed.

Each of the first sub-electrode SUE1 and the second sub-electrode SUE2 may extend along the second direction DR2. The first sub-electrode SUE1 and the second sub-electrode SUE2 may face each other (e.g., may be opposite to each other).

Each of the third sub-electrode SUE3 and the fourth sub-electrode SUE4 may extend along the first direction DR1. The third sub-electrode SUE3 and the fourth sub-electrode SUE4 may face each other (e.g., may be opposite to each other).

The second electrode EE2 may be located in (e.g., surrounded by, in plan view) the first electrode EE1. In other words, the second electrode EE2 may be located in the region surrounded by the first electrode EE1. The second electrode EE2 may extend from the inner surface of the first electrode EE1 along the first direction DR1. One side of the second electrode EE2 may be connected to the inner surface of the first sub-electrode SUE1, and the other side of the second electrode EE2 may be connected to the inner surface of the second sub-electrode SUE2. A plurality of second electrodes EE2 may be provided. FIG. 7 shows, for one example, that two second electrodes EE2 are spaced apart from each other in the first electrode EE1. However, the present disclosure is not limited thereto, and three or more second electrodes EE2 may be spaced apart from each other in the first electrode EE1. When the plurality of second electrodes EE2 are provided, the intervals between the second electrodes EE2 may be the same. In this case, the gap GP may exist between adjacent second electrodes EE2.

The third electrode EE3 may be located in the first electrode EE1. In other words, the third electrode EE3 may be located in the region surrounded by the first electrode EE1. The third electrode EE3 may extend from the inner surface of the first electrode EE1 along the second direction DR2. In other words, the third electrode EE3 may cross or intersect (for example, perpendicularly intersect) the aforementioned second electrode EE2. One side of the third electrode EE3 may be connected to the inner surface of the third sub-electrode SUE3, and the other side of the third electrode EE3 may be connected to the inner surface of the fourth sub-electrode SUE4. A plurality of third electrodes EE3 may be provided. FIG. 7 shows, for one example, that four third electrodes EE3 are spaced apart from each other in the first electrode EE1. However, the present disclosure is not limited thereto, and two or more third electrodes EE3 may be spaced apart from each other in the first electrode EE1. When the plurality of third electrodes EE3 are provided, the intervals between the third electrodes EE3 may be the same. In this case, the gap GP may exist between adjacent third electrodes EE3. The same gap GP may exist between adjacent third electrodes EE3 and adjacent second electrodes EE2, but the present disclosure is not limited thereto. In alternative examples, the gap existing between adjacent third electrodes EE3 is different to (e.g. smaller) the gap existing between adjacent second electrodes EE2.

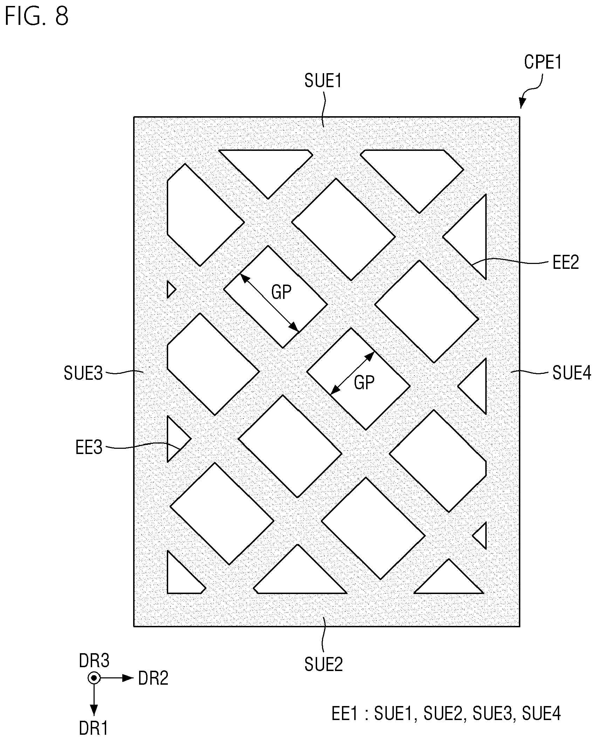

FIG. 8 is a plan view of the first capacitor electrode CPE1 of the display device according to one or more embodiments.

As shown in FIG. 8, the first capacitor electrode CPE1 may include the first electrode EE1, the second electrode EE2, and a third electrode EE3. The first electrode EE1, the second electrode EE2, and the third electrode EE3 may be integrally formed.

The first electrode EE1 may have a closed curve shape or a ring shape. For example, the first electrode may have a rectangular frame shape longer in the first direction DR1 than in the second direction DR2. The first electrode EE1 may include, for example, a first sub-electrode SUE1, a second sub-electrode SUE2, a third sub-electrode SUE3, and a fourth sub-electrode SUE4 connected to each other. The first sub-electrode SUE1, the second sub-electrode SUE2, the third sub-electrode SUE3, and the fourth sub-electrode SUE4 may be integrally formed.

Each of the first sub-electrode SUE1 and the second sub-electrode SUE2 may extend along the second direction DR2. The first sub-electrode SUE1 and the second sub-electrode SUE2 may face each other (e.g., may be opposite to each other).

Each of the third sub-electrode SUE3 and the fourth sub-electrode SUE4 may extend along the first direction DR1. The third sub-electrode SUE3 and the fourth sub-electrode SUE4 may face each other (e.g., may be opposite to each other).

The second electrode EE2 may be located in the first electrode EE1. In other words, the second electrode EE2 may be located in the region surrounded by the first electrode EE1. The second electrode EE2 may extend from the inner surface of the first electrode EE1 along a first oblique direction. Here, the first oblique direction may be defined as, for example, a direction between the first direction DR1 and the second direction DR2. A plurality of second electrodes EE2 may be provided. FIG. 8 shows, for one example, that five second electrodes EE2 are spaced apart from each other in the first electrode EE1. However, the present disclosure is not limited thereto, and two to four or six or more second electrodes EE2 may be spaced apart from each other in the first electrode EE1. When the plurality of second electrodes EE2 are provided, the intervals between the second electrodes EE2 may be the same. In this case, the gap GP may exist between adjacent second electrodes EE2.

The third electrode EE3 may be located in the first electrode EE1. In other words, the third electrode EE3 may be located in the region surrounded by the first electrode EE1. The third electrode EE3 may extend from the inner surface of the first electrode EE1 in a second oblique direction. Here, the second oblique direction may be the direction crossing or intersecting (for example, substantially perpendicularly intersecting) the aforementioned first oblique direction. For example, the second oblique direction may be the direction between the first reverse direction and the second reverse direction. A plurality of third electrodes EE3 may be provided. FIG. 8 shows, for one example, that four third electrodes EE3 are spaced apart from each other in the first electrode EE1. However, the present disclosure is not limited thereto, and two to three or five or more third electrodes EE3 may be spaced apart from each other in the first electrode EE1. When the plurality of third electrodes EE3 are provided, the intervals between the third electrodes EE3 may be the same. In this case, the gap GP may exist between adjacent third electrodes EE3. The same gap GP may exist between adjacent third electrodes EE3 and adjacent second electrodes EE2, but the present disclosure is not limited thereto. In alternative examples, the gap existing between adjacent third electrodes EE3 is different to (e.g. bigger) the gap existing between adjacent second electrodes EE2.

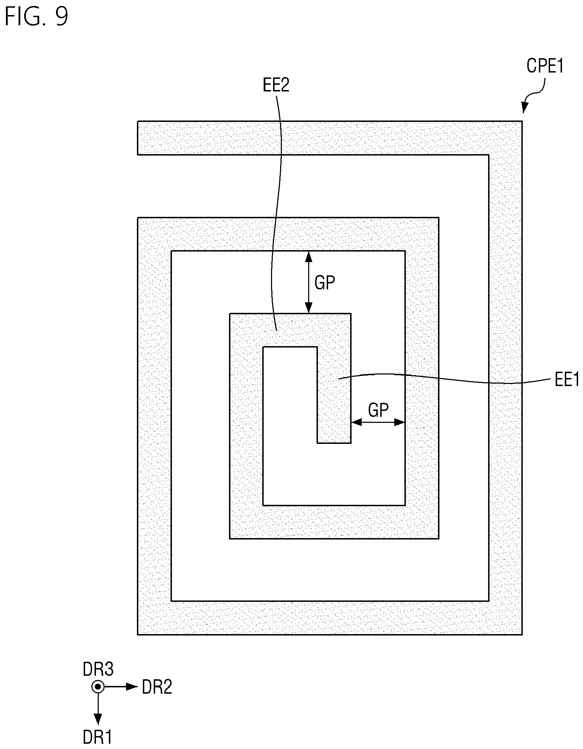

FIG. 9 is a plan view of the first capacitor electrode CPE1 of the display device according to one or more embodiments.

As shown in FIG. 9, the first capacitor electrode CPE1 may have a spiral shape with the gap GP. For example, the first capacitor electrode CPE1 may have a spiral structure in which a plurality of first electrodes EE1 and the plurality of second electrodes EE2 extend outwardly while rotating in a counterclockwise direction from a central portion. Here, each first electrode may extend in the first direction DR1, and each second electrode may extend in the second direction DR2. The gap GP may be formed between adjacent first electrodes, and the gap GP may be formed between adjacent second electrodes. In this case, the first capacitor electrode CPE1 may have a spiral structure having a generally rectangular shape as a whole. Alternatively, the first capacitor electrode CPE1 may have a spiral structure having a generally circular or elliptical shape as a whole.

Meanwhile, in one or more embodiments, the first capacitor electrode CPE1 may have a spiral structure extending outwardly while rotating in a clockwise direction from the central portion. In this case, the first capacitor electrode CPE1 may have a spiral structure having a rectangular shape as a whole. Alternatively, the first capacitor electrode CPE1 may have a spiral structure having a circular or elliptical shape as a whole.

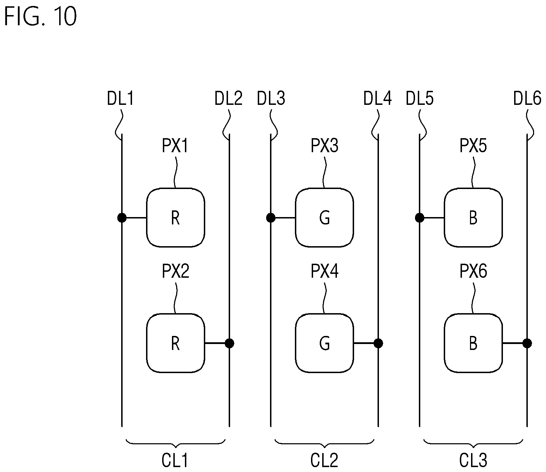

FIG. 10 is a diagram showing arrangement of pixels of a display device according to one or more embodiments.

As shown in FIG. 10, the display device may include a plurality of pixels PX1, PX2, PX3, PX4, PX5, and PX6.

The pixels PX1, PX2, PX3, PX4, PX5, and PX6 may be connected to data lines DL1, DL2, DL3, DL4, DL5, and DL6, respectively. For example, the first pixel PX1 and the second pixel PX2 located in a first column CL1 between the first data line DL1 and the second data line DL2 adjacent to each other may be connected to the first data line DL1 and the second data line DL2, respectively. The third pixel PX3 and the fourth pixel PX4 located in a second column CL2 between the third data line DL3 and the fourth data line DL4 adjacent to each other may be connected to the third data line DL3 and the fourth data line DL4, respectively. The fifth pixel PX5 and the sixth pixel PX6 located in a third column CL3 between the fifth data line DL5 and the sixth data line DL6 adjacent to each other may be connected to the fifth data line DL5 and the sixth data line DL6, respectively. In other words, the first pixel PX1 of the first column CL1 may be connected to the first data line DL1, the second pixel PX2 of the first column CL1 may be connected to the second data line DL2, the third pixel PX3 of the second column CL2 may be connected to the third data line DL3, the fourth pixel PX4 of the second column CL2 may be connected to the fourth data line DL4, the fifth pixel PX5 of the third column CL3 may be connected to the fifth data line DL5, and the sixth pixel PX6 of the third column CL3 may be connected to the sixth data line DL6.

The pixels arranged in the same column may provide light of the same color, and the pixels arranged in different columns may provide lights of different respective colors. For example, each of the pixels PX1 and PX2 of the first column CL1 may provide light of a first color, each of the pixels PX3 and PX4 of the second column CL2 may provide light of a second color, and each of the pixels PX5 and PX6 of the third column CL3 may provide light of a third color. In one example, the first color may be red, the second color may be green, and the third color may be blue. However, the present disclosure is not limited thereto, and the first color may be any one of green and blue, the second color may be any one of red and blue, and the third color may be any one of red and green.

In the display device according to one or more embodiments, a plurality of pixels arranged in the same column may be driven by two data lines, so that the driving speed of the display device may be improved. For example, the display device of one or more embodiments may be driven at about 120 Hz or higher.

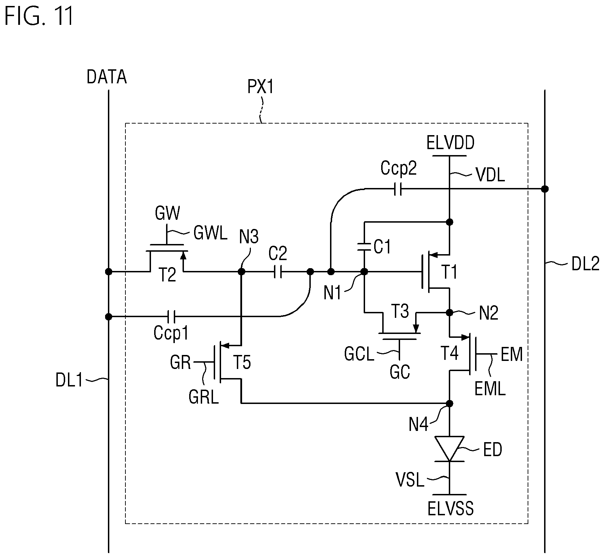

FIG. 11 is a circuit configuration diagram of the first pixel shown in FIG. 10.

As shown in FIG. 11, the first pixel PX1 may include a first transistor T1, a second transistor T2, a third transistor T3, a fourth transistor T4, a fifth transistor T5, a first capacitor C1, a second capacitor C2, and a light-emitting element ED.

The first transistor T1 may include a first gate electrode connected to a first node N1 (or gate node), a first source electrode connected to a driving voltage line VDL, and a first drain electrode connected to a second node N2. The first drain electrode of the first transistor T1 may be connected to the pixel electrode (or anode electrode) of the light-emitting element ED via the fourth transistor T4. The first transistor T1 may serve as a driving transistor, and may control the magnitude (e.g., current amount) of a driving current flowing to the light-emitting element ED by receiving the data signal DATA according to the switching operation of the second transistor T2.

The second transistor T2 may include a first gate electrode GE1 connected to a first scan line GWL, a second source electrode connected to the first data line DL1, and a second drain electrode connected to a third node. The second transistor T2 may be turned on according to the first scan signal GW transmitted to the first scan line GWL to electrically connect the data line DL1 to the third node N3, and may transmit the data signal DATA transmitted to the data line DL1 to the third node N3.

The third transistor T3 may include a third gate electrode connected to a second scan line GCL, a third drain electrode connected to the first node N1, and a third source electrode connected to the second node N2. The third transistor T3 may be turned on according to a second scan signal GC transmitted to the second scan line GCL to electrically connect the first node N1 and the second node N2.

The fourth transistor T4 may include a fourth gate electrode connected to an emission control line EML, a fourth source electrode connected to the second node N2, and a fourth drain electrode connected to a fourth node N4 (or pixel electrode or anode electrode). The fourth transistor T4 may be turned-on or turned-off according to an emission control signal EM transmitted to the emission control line EML.

The fifth transistor T5 may include a fifth gate electrode connected to the third scan line GRL, a fifth source electrode connected to the third node N3, and a fifth drain electrode connected to the fourth node N4. The fifth transistor T5 may be turned on according to a third scan signal GR transmitted to the third scan line GRL to electrically connect the third node N3 and the fourth node N4.

The first capacitor C1 may be connected between the first node N1 and the driving voltage line VDL.

The second capacitor C2 may be connected between the third node N3 and the first node N1.

The light-emitting element ED may include a pixel electrode (or an anode electrode) and a counter electrode (e.g., a cathode electrode) facing the pixel electrode, and the counter electrode may be applied with a common voltage ELVSS. The counter electrode may be connected to a common voltage line VSL transmitting a common voltage. The counter electrode may be a common electrode commonly shared by the plurality of pixels PX.

The other pixels PX2 to PX6 of FIG. 11 may also have the same circuit configuration as that of the first pixel PX1 of FIG. 11 described above.

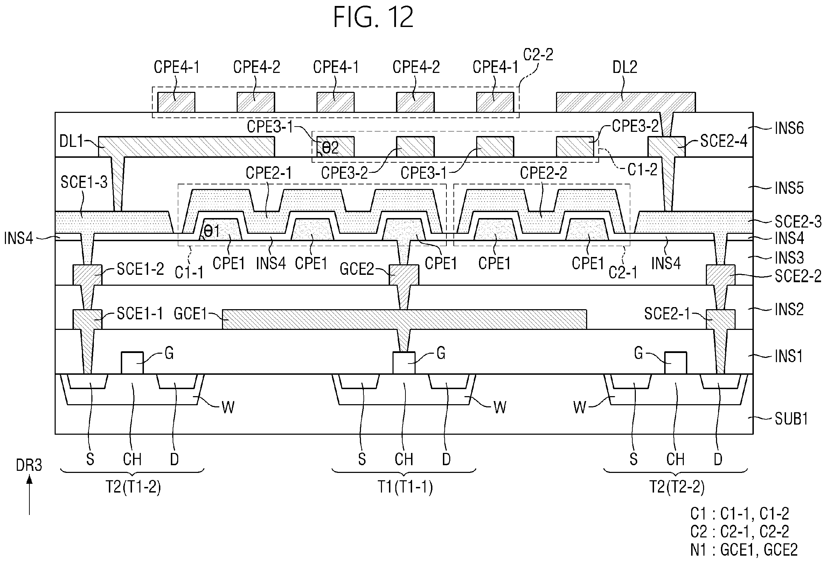

Meanwhile, as shown in FIG. 11, the data lines are respectively located on both sides of one pixel, so that a first coupling capacitor Ccp1 may be formed between the first data line DL1 and the gate electrode of the driving transistor (for example, the first transistor T1), and a second coupling capacitor Ccp2 may be formed between the second data line DL2 and the gate electrode of the driving transistor T1. The first coupling capacitor Ccp1 and the second coupling capacitor Ccp2 may cause crosstalk (for example, vertical crosstalk) to deteriorate the image quality of the display device. However, the display device according to one or more embodiments may reduce or minimize the crosstalk using the capacitor CPT having the structure shown in FIG. 2 (or FIG. 5) described above. This will be described in detail with reference to FIG. 12.

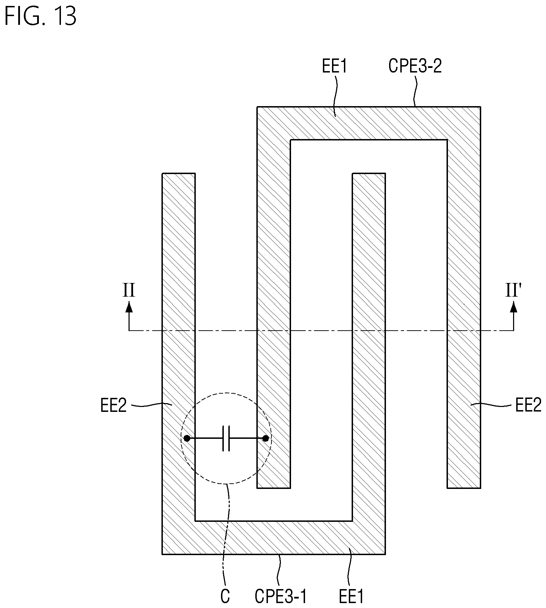

FIG. 12 is a cross-sectional view of a display device according to one or more embodiments, and FIG. 13 is a plan view of one or more embodiments of a first-second capacitor of FIG. 12. The cross-sectional view taken along the line II-II' of FIG. 13 may correspond to the first-second capacitor C1-2 of FIG. 12.

Referring to FIG. 12, the second transistor T2 (hereinafter, referred to as a first-second transistor T1-2) of the first pixel PX1, the first transistor T1 (hereinafter, referred to as a first-first transistor T1-1) of the first pixel PX1, and the second transistor T2 (hereinafter, referred to as a second-second transistor T2-2) of the second pixel PX2 may be located on the base substrate SUB1.

Each of the transistors T1-2, T1-1, and T2-2 may include a gate electrode G, the source electrode S, and the drain electrode D.

The first insulating layer INS1 may be located on the base substrate SUB1.

A first-first source connection electrode SCE1 -1, a first gate connection electrode GCE1, and a second-first source connection electrode SCE2-1 may be located on the first insulating layer INS1.

The first-first source connection electrode SCE1-1 may be connected to the source electrode S of the first-second transistor T1-2 through the contact hole of the first insulating layer INS1.

The first gate connection electrode GCE1 may be connected to the gate electrode G of the first-first transistor T1-1 through the contact hole of the first insulating layer INS1.

The second-first source connection electrode SCE2-1 may be connected to the source electrode S of the second-second transistor T2-2 through the contact hole of the first insulating layer INS1.

The second insulating layer INS2 may be located on the first-first source connection electrode SCE1-1, the first gate connection electrode GCE1, and the second-first source connection electrode SCE2-1.

A first-second source connection electrode SCE1-2, a second gate connection electrode GCE2, and a second-second source connection electrode SCE2-2 may be located on the second insulating layer INS2.

The first-second source connection electrode SCE1-2 may be connected to the first-first source connection electrode SCE1-1 through the contact hole of the second insulating layer INS2.

The second gate connection electrode GCE2 may be connected to the first gate connection electrode GCE1 through the contact hole of the second insulating layer INS2.

The second-second source connection electrode SCE2-2 may be connected to the second-first source connection electrode SCE2-1 through the contact hole of the second insulating layer INS2.

The third insulating layer INS3 may be located on the first-second source connection electrode SCE1-2, the second gate connection electrode GCE2, and the second-second source connection electrode SCE2-2. The third insulating layer INS3 may be the same as, or may include the same material as, the first insulating layer INS1 of FIG. 4 described above, for example.

The display device may include the first capacitor C1 and the second capacitor C2 located on the third insulating layer INS3.

The first capacitor C1 may include a first-first capacitor C1-1 and a first-second capacitor C1-2 located on different layers and connected to each other.

The first-first capacitor C1-1 may include the first capacitor electrode CPE1 and a second-first capacitor electrode CPE2-1 overlapping each other in the vertical direction (for example, the third direction DR3).

The first-second capacitor C1-2 may include a third-first capacitor electrode CPE3-1 and a third-second capacitor electrode CPE3-2 overlapping each other in a horizontal direction (for example, the second direction DR2 and/or the first direction DR1).

The second capacitor C2 may include a second-first capacitor C2-1 and a second-second capacitor C2-2 located on different layers and connected to each other.

The second-first capacitor C2-1 may include the first capacitor electrode CPE1 and a second-second capacitor electrode CPE2-2 overlapping each other in the vertical direction (for example, the third direction DR3).

The second-second capacitor C2-2 may include a fourth-first capacitor electrode CPE4-1 and a fourth-second capacitor electrode CPE4-2 overlapping each other in the horizontal direction (for example, the second direction DR2 and/or the first direction DR1).

The structures of the first capacitor C1 and the second capacitor C2 will be described in detail.

The first capacitor electrode CPE1 may be located on the third insulating layer INS3. The first capacitor electrode CPE1 may be, for example, the first electrode of the first-first capacitor C1-1 and the first electrode of the second-first capacitor C2-1. In other words, the first capacitor electrode CPE1 may be the common capacitor electrode shared by the first-first capacitor C1-1 and the second-first capacitor C2-1. The first capacitor electrode CPE1 may be connected to the second gate connection electrode GCE2 through the contact hole of the third insulating layer INS3. The first capacitor electrode CPE1 may have the same shape as that of any one of the first capacitor electrodes CPE1 of FIGS. 2, 3, 4, 6, 7, 8, and 9 described above, for example.

A fourth insulating layer INS4 may be located on the first capacitor electrode CPE1. The fourth insulating layer INS4 may be the same as, or may include a same material as, the second insulating layer INS2 of FIG. 4 described above, for example.

A first-third source connection electrode SCE1-3, the second-first capacitor electrode CPE2-1, the second-second capacitor electrode CPE2-2, and a second-third source connection electrodes SCE2-3 may be located on the fourth insulating layer INS4.

The first-third source connection electrode SCE1-3 may be connected to the first-second source connection electrode SCE1-2 through the contact hole of the fourth insulating layer INS4.

The second-first capacitor electrode CPE2-1 may be located on the fourth insulating layer INS4 to overlap the first capacitor electrode CPE1 of the first-first capacitor C1-1. The second-first capacitor electrode CPE2-1 may be, for example, the second electrode of the first-first capacitor C1-1. In one or more embodiments, the second-first capacitor electrode CPE2-1 may be connected to the driving voltage line VDL. The second-first capacitor electrode CPE2-1 may have the same shape as that of any one of the second capacitor electrodes CPE2 of FIGS. 2, 3, 4, 6, 7, 8, and 9 described above, for example.

The second-second capacitor electrode CPE2-2 may be located on the fourth insulating layer INS4 to overlap the first capacitor electrode CPE1 of the second-first capacitor C2-1. The second-second capacitor electrode CPE2-2 may be, for example, the second electrode of the second-first capacitor C2-1. In one or more embodiments, the second-second capacitor electrode CPE2-2 may be connected to the drain electrode D of the first-second transistor T1-2. The second-second capacitor electrode CPE2-2 may have the same shape as that of any one of the second capacitor electrodes CPE2 of FIGS. 2, 3, 4, 6, 7, 8, and 9 described above, for example.

The second-third source connection electrode SCE2-3 may be connected to the second-second source connection electrode SCE2-2 through the contact hole of the fourth insulating layer INS4.

A fifth insulating layer INS5 may be located on the first-third source connection electrode SCE1-3, the second-first capacitor electrode CPE2-1, the second-second capacitor electrode CPE2-2, and the second-third source connection electrode SCE2-3. The fifth insulating layer INS5 may be the same as, or may include the same material as, the third insulating layer INS3 of FIG. 4 described above, for example.

The first data line DL1, the third-first capacitor electrode CPE3-1, the third-second capacitor electrode CPE3-2, and a second-fourth source connection electrode SCE2-4 may be located on the fifth insulating layer INS5.

The first data line DL1 may be connected to the first-third source connection electrodes SCE1-3 through the contact hole of the fifth insulating layer INS5.

The third-first capacitor electrode CPE3-1 may have a U-shape, as in the example shown in FIG. 13. For example, the third-first capacitor electrode CPE3-1 may include the first electrode EE1, and the plurality of second electrodes EE2 extending from the first electrode EE1. In one or more embodiments, the third-first capacitor electrode CPE3-1 may be connected to the first capacitor electrode CPE1 through the contact hole penetrating the fifth insulating layer INS5 and the fourth insulating layer INS4. The third-first capacitor electrode CPE3-1 may be, for example, the first electrode of the first-second capacitor C1-2.

The third-second capacitor electrode CPE3-2 may have a U-shape (e.g., upside down U-shape) having the first electrode EE1 and the second electrodes EE2, as in the example shown in FIG. 13. For example, the third-second capacitor electrode CPE3-2 may have a shape in which the third-first capacitor electrode CPE3-1 is upside down. At least one second electrode EE2 of the third-second capacitor electrode CPE3-2 may be located between the second electrodes EE2 of the third-first capacitor CPE3-1, and at least one second electrode EE2 of the third-first capacitor electrode CPE3-1 may be located between the second electrodes EE2 of the third-second capacitor electrode CPE3-2. A capacitor C may be formed between respective facing surfaces of the third-second capacitor electrode CPE3-2 and the third-first capacitor electrode CPE3-1. In one or more embodiments, the third-second capacitor electrode CPE3-2 may be connected to the second-first capacitor electrode CPE2-1 through the contact hole of the fifth insulating layer INS5. The third-second capacitor electrode CPE3-2 may be, for example, the second electrode of the first-second capacitor C1-2.

The second-fourth source connection electrode SCE2-4 may be connected to the second-third source connection electrode SCE2-3 through the contact hole of the fifth insulating layer INS5.

A sixth insulating layer INS6 may be located on the first data line DL1, the third-first capacitor electrode CPE3-1, the third-second capacitor electrode CPE3-2, and the second-fourth source connection electrode SCE2-4. The sixth insulating layer INS6 may be the same as, or may include the same material as, the third insulating layer INS3 of FIG. 4 described above, for example.

The fourth-first capacitor electrode CPE4-1, the fourth-second capacitor electrode CPE4-2, and the second data line DL2 may be located on the sixth insulating layer INS6.

The fourth-first capacitor electrode CPE4-1 may have the same shape as that of the third-first capacitor electrode CPE3-1 described above. However, as shown in FIG. 12, the fourth-first capacitor electrode CPE4-1 may include a larger number of second electrodes compared to the third-first capacitor electrode CPE3-1. In one or more embodiments, the fourth-first capacitor electrode CPE4-1 may be connected to the first capacitor electrode CPE1 through the contact hole penetrating the sixth insulating layer INS6, the fifth insulating layer INS5, and the fourth insulating layer INS4. The fourth-first capacitor electrode CPE4-1 may be, for example, the first electrode of the second-second capacitor C2-2.

The fourth-second capacitor electrode CPE4-2 may have the same shape as that of the aforementioned third-second capacitor electrode CPE3-2. However, as shown in FIG. 12, the fourth-second capacitor electrode CPE4-2 may include a larger number of second electrodes compared to the third-second capacitor electrode CPE3-2. In one or more embodiments, the fourth-second capacitor electrode CPE4-2 may be connected to the second-second capacitor electrode CPE2-2 through the contact hole penetrating the sixth insulating layer INS6 and the fifth insulating layer INS5. The fourth-second capacitor electrode CPE4-2 may be, for example, the second electrode of the second-second capacitor C2-2.

The second data line DL2 may be connected to the second-fourth source connection electrodes SCE2-4 through the contact hole of the sixth insulating layer INS6.

As shown in FIG. 12, when the angle θ1 formed by the bottom surface and one side surface of the first capacitor electrode CPE1 is defined as a first tapered angle, and an angle θ2 formed by the bottom surface and one side surface of the third-first capacitor electrode CPE3-1 is defined as a second tapered angle, the first tapered angle θ1 may be smaller than the second tapered angle θ2.

Referring to FIG. 12, the capacitors (for example, the first-first capacitor C1-1 and the second-first capacitor C2-1) may be respectively located between/interposed the first data line DL1 and the gate electrode G of the first transistor T1-1, and located between/interposed the second data line DL2 and the gate electrode G of the first transistor T1-1. In other words, the capacitors (for example, the first-first capacitor C1 - 1 and the second-first capacitor C2-1) may be respectively located between the first data line DL1 and the gate nodes N1 (GCE1 and GCE2), and between the second data line DL2 and the gate nodes N1 (GCE1 and GCE2). Neither electrode of first-first capacitor C1-1 is connected to the first data line DL1, and neither electrode of second-first capacitor C2-1 is connected to second data line DL2. The first-first capacitor C1-1 being "located between" the first data line DL1 and the gate nodes N1 means the electrodes of the first-first capacitor C1-1 are located/physically disposed within the display device between the first data line DL1 and the gate nodes N1, and the second-first capacitor C2-1 being "located between" the second data line DL2 and the gate nodes N1 means the electrodes of the second-first capacitor C2-1 are located/physically disposed between the second data line DL2 and the gate nodes N1. In this case, the capacitors (for example, the first-first capacitor C1-1 and the second-first capacitor C2-1) may respectively overlap the first data line DL1 and the second data line DL2 in the third direction DR3. The first-first capacitor C1-1 and the second-first capacitor C2-1 may reduce or prevent the likelihood of the formation of the coupling capacitors Ccp1 and Ccp2 between the data lines DL1 and DL2 and the gate nodes N1 (GCE1 and GCE2), respectively. In addition, the first-first capacitor C1-1 and the second-first capacitor C2-1 include a structure that may have a large capacitance as described above, and thus are more advantageous in removing the coupling capacitors Ccp1 and Ccp2 as described above.

Further, as shown in FIG. 12, the second data line DL2 is located on a layer that is higher than the first data line DL1, so that the second data line DL2 may be relatively more distant from the gate node N1. Accordingly, the coupling capacitor Ccp2 between the second data line DL2 and the gate node N1 may be further reduced or minimized.

Meanwhile, due to the added data line (for example, the second data line DL2), the formation space of the second-second capacitor C2-2 located on the same layer as the second data line DL2 becomes relatively small and, thus, the capacitance of the second-second capacitor C2-2 may be slightly decreased. However, this may be sufficiently compensated by the first-first capacitor C1-1 and the second-first capacitor C2-2 that may have relatively large capacitances.

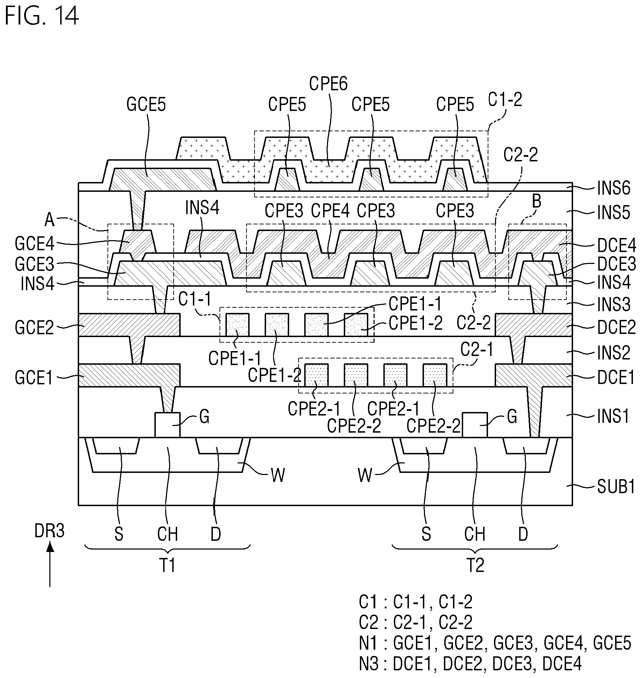

FIG. 14 is a cross-sectional view of a display device according to one or more embodiments.

Referring to FIG. 14, the first transistor T1 of the first pixel PX1 and the second transistor T2 of the first pixel PX1 may be located on the base substrate SUB1.

Each of the transistors T1 and T2 may include a gate electrode G, the source electrode S, and the drain electrode D.

The first insulating layer INS1 may be located on the base substrate SUB1.

The display device may include the first capacitor C1 and the second capacitor C2 located on (e.g., above) the first insulating layer INS1.

The first capacitor C1 may include the first-first capacitor C1-1 and the first-second capacitor C1-2 located on different layers and connected to each other.

The first-first capacitor C1-1 may include the first-first capacitor electrode CPE1-1 and the first-second capacitor electrodes CPE1-2 located on the same layer, and overlapping each other in the horizontal direction (for example, the second direction DR2 and/or the first direction DR1). The first-first capacitor C1-1 may have substantially the same structure as that of the first-second capacitor C1-2 of FIGS. 12 and 13 described above.

The first-second capacitor C1-2 may include a fifth capacitor electrode CPE5 and a sixth capacitor electrode CPE6 located on different layers and overlapping each other in the vertical direction (for example, the third direction DR3). The first-second capacitor C1-2 may have the same structure as that of the capacitor CPT of FIG. 4 described above.

The second capacitor C2 may include the second-first capacitor C2-1 and the second-second capacitor C2-2 located on different respective layers and connected to each other.

The second-first capacitor C2-1 may include the second-first capacitor electrode CPE2-1 and the second-second capacitor electrode CPE2-2 located on the same layer and overlapping each other in the horizontal direction (for example, the second direction DR2 and/or the first direction DR1). The second-first capacitor C2-1 may have substantially the same structure as that of the first-second capacitor C1-2 of FIGS. 12 and 13 described above.

The second-second capacitor C2-2 may include a third capacitor electrode CPE3 and a fourth capacitor electrode CPE4 located on different layers and overlapping in the vertical direction (for example, the third direction DR3). The second-second capacitor C2-2 may have the same structure as that of the capacitor CPT of FIG. 4 described above.

The structures of the first capacitor C1 and the second capacitor C2 will be described in detail.

The first gate connection electrode GCE1, the second-first capacitor electrode CPE2-1, the second-second capacitor electrode CPE2-2, and a first drain connection electrode DCE1 may be located on the first insulating layer INS1.

The first gate connection electrode GCE1 may be connected to the gate electrode G of the first transistor T1 through the contact hole of the first insulating layer INS1.

The second-first capacitor electrode CPE2-1 may be connected to the first drain connection electrode DCE1. For example, the second-first capacitor electrode CPE2-1 and the first drain connection electrode DCE1 may be integrally formed. The second-first capacitor electrode CPE2-1 may be, for example, the second electrode of the second-first capacitor C2-1.

The second-second capacitor electrode CPE2-2 may be connected to the first gate connection electrode GCE1. For example, the second-second capacitor electrode CPE2-2 and the first gate connection electrode GCE1 may be integrally formed. The second-second capacitor electrode CPE2-2 may be, for example, the first electrode of the second-first capacitor C2-1.

The first drain connection electrode DCE1 may be connected to the drain electrode D of the second transistor T2 through the contact hole of the first insulating layer INS1.

The second insulating layer INS2 may be located on the first gate connection electrode GCE1, the second-first capacitor electrode CPE2-1, the second-second capacitor electrode CPE2-2, and the first drain connection electrode DCE1.

The second gate connection electrode GCE2, the first-first capacitor electrode CPE1-1, the first-second capacitor electrode CPE1-2, and a second drain connection electrode DCE2 may be located on the second insulating layer INS2.

The second gate connection electrode GCE2 may be connected to the first gate connection electrode GCE1 through the contact hole of the first insulating layer INS2.

The first-first capacitor electrode CPE1-1 may be connected to the second drain connection electrode DCE2. For example, the first-first capacitor electrode CPE1-1 and the second drain connection electrode DCE2 may be integrally formed. The first-first capacitor electrode CPE1-1 may be, for example, the second electrode of the first-first capacitor C1-1.

The first-second capacitor electrode CPE1-2 may be connected to the second gate connection electrode GCE2. For example, the first-second capacitor electrode CPE1-2 and the second gate connection electrode GCE2 may be integrally formed. The first-second capacitor electrode CPE1-2 may be, for example, the first electrode of the first-first capacitor C1-1.

The second drain connection electrode DCE2 may be connected to the first drain connection electrode DCE1 through the contact hole of the first insulating layer INS2.

The third insulating layer INS3 may be located on the second gate connection electrode GCE2, the first-first capacitor electrode CPE1-1, the first-second capacitor electrode CPE1-2, and the second drain connection electrode DCE2.

A third gate connection electrode GCE3, the third capacitor electrode CPE3, and a third drain connection electrode DCE3 may be located on the third insulating layer INS3.

The third gate connection electrode GCE3 may be connected to the second gate connection electrode GCE2 through the contact hole of the third insulating layer INS3.

The third capacitor electrode CPE3 may be, for example, the first electrode of the second-second capacitor C2-2. The third capacitor electrode CPE3 may be connected to the third gate connection electrode GCE3. For example, the third capacitor electrode CPE3 and the third gate connection electrode GCE3 may be integrally formed. The third capacitor electrode CPE3 may have the same shape as that of any one of the first capacitor electrodes CPE1 of FIGS. 2, 3, 4, 6, 7, 8, and 9 described above, for example.

The third drain connection electrode DCE3 may be connected to the second drain connection electrode DCE2 through the contact hole of the third insulating layer INS3.

The fourth insulating layer INS4 may be located on the third gate connection electrode GCE3, the third capacitor electrode CPE3, and the third drain connection electrode DCE3.

A fourth gate connection electrode GCE4, the fourth capacitor electrode CPE4, and a fourth drain connection electrode DCE4 may be located on the fourth insulating layer INS4.

The fourth gate connection electrode GCE4 may be connected to the third gate connection electrode GCE3 through the contact hole of the fourth insulating layer INS4.

The fourth capacitor electrode CPE4 may be located on the fourth insulating layer INS4 to overlap the third capacitor electrode CPE3. The fourth capacitor electrode CPE4 may be, for example, the second electrode of the second-second capacitor C2-2. The fourth capacitor electrode CPE4 may have the same shape as that of any one of the second capacitor electrodes CPE2 of FIGS. 2, 3, 4, 6, 7, 8, and 9 described above, for example.

The fourth drain connection electrode DCE4 may be connected to the third drain connection electrode DCE3 through the contact hole of the fourth insulating layer INS4. Further, the fourth drain connection electrode DCE4 may be connected to the fourth capacitor electrode CPE4. For example, the fourth drain connection electrode DCE4 and the fourth capacitor electrode CPE4 may be integrally formed.

The fifth insulating layer INS5 may be located on the fourth gate connection electrode GCE4, the fourth capacitor electrode CPE4, and the fourth drain connection electrode DCE4.

A fifth gate connection electrode GCE5 and the fifth capacitor electrode CPE5 may be located on the fifth insulating layer INS5.

The fifth gate connection electrode GCE5 may be connected to the fourth gate connection electrode GCE4 through the contact hole of the fifth insulating layer INS5.

The fifth capacitor electrode CPE5 may be, for example, the first electrode of the first-second capacitor C1-2. The fifth capacitor electrode CPE5 may be connected to the fifth gate connection electrode GCE5. For example, the fifth capacitor electrode CPE5 and the fifth gate connection electrode GCE5 may be integrally formed. The fifth capacitor electrode CPE5 may have the same shape as that of any one of the first capacitor electrodes CPE1 of FIGS. 2, 3, 4, 6, 7, 8, and 9 described above, for example.

The sixth insulating layer INS6 may be located on the fifth gate connection electrode GCE5 and the fifth capacitor electrode CPE5.

The sixth capacitor electrode CPE6 may be located on the sixth insulating layer INS6.

The sixth capacitor electrode CPE6 may be located on the sixth insulating layer INS6 to overlap the fifth capacitor electrode CPE5. The sixth capacitor electrode CPE6 may be, for example, the second electrode of the first-second capacitor C1-2. The sixth capacitor electrode CPE6 may have the same shape as that of any one of the second capacitor electrodes CPE2 of FIGS. 2, 3, 4, 6, 7, 8, and 9 described above, for example. Meanwhile, the sixth capacitor electrode CPE6 may be connected to the driving voltage line VDL. For example, the sixth capacitor electrode CPE6 and the driving voltage line VDL may be integrally formed.

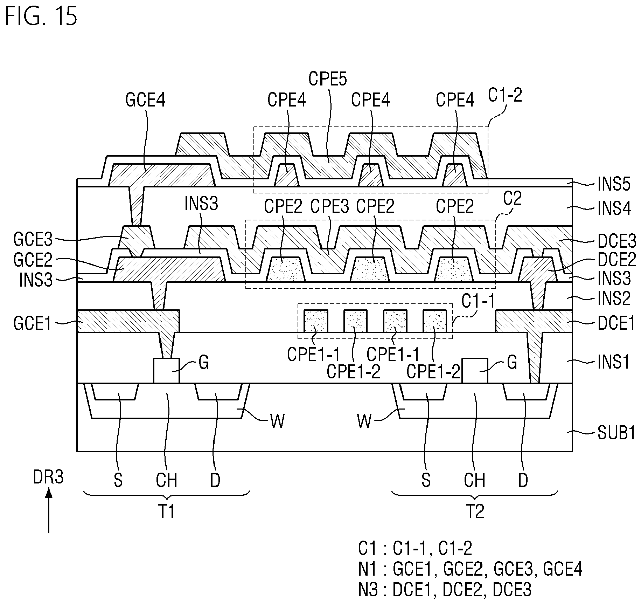

FIG. 15 is a cross-sectional view of a display device according to one or more embodiments.

Referring to FIG. 15, the first transistor T1 of the first pixel PX1 and the second transistor T2 of the first pixel PX1 may be located on the base substrate SUB1.

Each of the transistors T1 and T2 may include the gate electrode G, the source electrode S, and the drain electrode D.

The first insulating layer INS1 may be located on the base substrate SUB1.

The display device may include the first capacitor C1 and the second capacitor C2 located on the first insulating layer INS1.

The first capacitor C1 may include the first-first capacitor C1-1 and the first-second capacitor C1-2 located on different respective layers and connected to each other.

The first-first capacitor C1-1 may include the first-first capacitor electrode CPE1-1 and the first-second capacitor electrodes CPE1-2 located on the same layer and overlapping each other in the horizontal direction (for example, the second direction DR2 and/or the first direction DR1). The first-first capacitor C1-1 may have substantially the same structure as that of the first-second capacitor C1-2 of FIGS. 12 and 13 described above.

The first-second capacitor C1-2 may include the fourth capacitor electrode CPE4 and the fifth capacitor electrode CPE5 located on different layers and overlapping in the vertical direction (for example, the third direction DR3). The first-second capacitor C1-2 may have the same structure as that of the capacitor CPT of FIG. 4 described above.

The second capacitor C2 may include the second capacitor electrode CPE2 and the third capacitor electrode CPE3 located on different layers and overlapping each other in the vertical direction (for example, the third direction DR3). The second capacitor C2 may have the same structure as that of the capacitor CPT of FIG. 4 described above.

The structures of the first capacitor C1 and the second capacitor C2 will be described in detail.

The first gate connection electrode GCE1, the first-first capacitor electrode CPE1-1, the first-second capacitor electrode CPE1-2, and the first drain connection electrode DCE1 may be located on the first insulating layer INS1.

The first gate connection electrode GCE1 may be connected to the gate electrode G of the first transistor T1 through the contact hole of the first insulating layer INS1.

The first-first capacitor electrode CPE1-1 may be connected to the first drain connection electrode DCE1. For example, the first-first capacitor electrode CPE1-1 and the first drain connection electrode DCE1 may be integrally formed. The first-first capacitor electrode CPE1-1 may be, for example, the second electrode of the first-first capacitor C1-1.

The first-second capacitor electrode CPE1-2 may be connected to the first gate connection electrode GCE1. For example, the first-second capacitor electrode CPE1-2 and the first gate connection electrode GCE1 may be integrally formed. The first-second capacitor electrode CPE1-2 may be, for example, the first electrode of the first-first capacitor C1-1.

The first drain connection electrode DCE1 may be connected to the drain electrode D of the second transistor T2 through the contact hole of the first insulating layer INS1.

The second insulating layer INS2 may be located on the first gate connection electrode GCE1, the first-first capacitor electrode CPE1-1, the first-second capacitor electrode CPE1-2, and the first drain connection electrode DCE1.

The second gate connection electrode GCE2, the second capacitor electrode CPE2, and the second drain connection electrode DCE2 may be located on the second insulating layer INS2.

The second gate connection electrode GCE2 may be connected to the first gate connection electrode GCE1 through the contact hole of the second insulating layer INS2.

The second capacitor electrode CPE2 may be, for example, the first electrode of the second capacitor C2. The second capacitor electrode CPE2 may be connected to the second gate connection electrode GCE2. For example, the second capacitor electrode CPE2 and the second gate connection electrode GCE2 may be integrally formed. The second capacitor electrode CPE2 may have the same shape as that of any one of the first capacitor electrodes CPE1 of FIGS. 2, 3, 4, 6, 7, 8, and 9 described above, for example.

The second drain connection electrode DCE2 may be connected to the first drain connection electrode DCE1 through the contact hole of the second insulating layer INS2.

The third insulating layer INS3 may be located on the second gate connection electrode GCE2, the third capacitor electrode CPE3, and the second drain connection electrode DCE2.

The third gate connection electrode GCE3, the third capacitor electrode CPE3, and the third drain connection electrode DCE3 may be located on the third insulating layer INS3.

The third gate connection electrode GCE3 may be connected to the second gate connection electrode GCE2 through the contact hole of the third insulating layer INS3.

The third capacitor electrode CPE3 may be located on the third insulating layer INS3 to overlap the second capacitor electrode CPE2. The third capacitor electrode CPE3 may be, for example, the second electrode of the second capacitor C2. The third capacitor electrode CPE3 may have the same shape as that of any one of the second capacitor electrodes CPE2 of FIGS. 2, 3, 4, 6, 7, 8, and 9 described above, for example.

The third drain connection electrode DCE3 may be connected to the second drain connection electrode DCE2 through the contact hole of the third insulating layer INS3. Further, the third drain connection electrode DCE3 may be connected to the third capacitor electrode CPE3. For example, the third drain connection electrode DCE3 and the third capacitor electrode CPE3 may be integrally formed.

The fourth insulating layer INS4 may be located on the third gate connection electrode GCE3, the third capacitor electrode CPE3, and the third drain connection electrode DCE3.

The fourth gate connection electrode GCE4 and the fourth capacitor electrode CPE4 may be located on the fourth insulating layer INS4.

The fourth gate connection electrode GCE4 may be connected to the third gate connection electrode GCE3 through the contact hole of the fourth insulating layer INS4.

The fourth capacitor electrode CPE4 may be, for example, the first electrode of the first-second capacitor C1-2. The fourth capacitor electrode CPE4 may be connected to the fourth gate connection electrode GCE4. For example, the fourth capacitor electrode CPE4 and the fourth gate connection electrode GCE4 may be integrally formed. The fourth capacitor electrode CPE4 may have the same shape as that of any one of the first capacitor electrodes CPE1 of FIGS. 2, 3, 4, 6, 7, 8, and 9 described above, for example.

The fifth insulating layer INS5 may be located on the fourth gate connection electrode GCE4 and the fourth capacitor electrode CPE4.

The fifth capacitor electrode CPE5 may be located on the fifth insulating layer INS5. The fifth capacitor electrode CPE5 may be located on the fifth insulating layer INS5 to overlap the fourth capacitor electrode CPE4. The fifth capacitor electrode CPE5 may be, for example, the second electrode of the first-second capacitor C1-2. The fifth capacitor electrode CPE5 may have the same shape as that of any one of the second capacitor electrodes CPE2 of FIGS. 2, 3, 4, 6, 7, 8, and 9 described above, for example. Meanwhile, the fifth capacitor electrode CPE5 may be connected to the driving voltage line VDL. For example, the fifth capacitor electrode CPE5 and the driving voltage line VDL may be integrally formed.

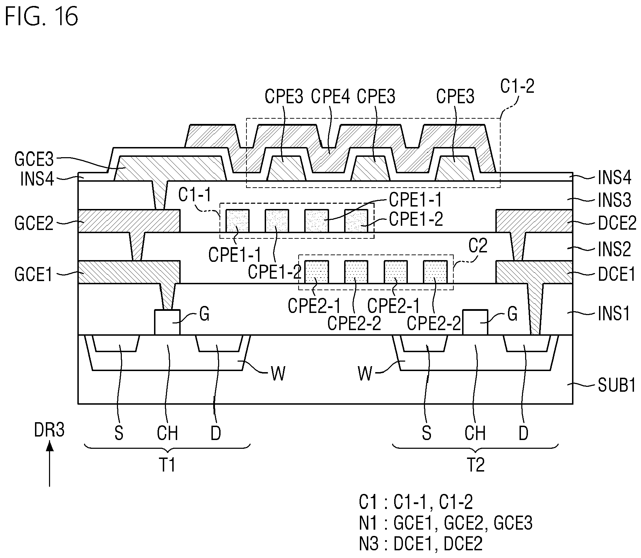

FIG. 16 is a cross-sectional view of a display device according to one or more embodiments.

Referring to FIG. 16, the first transistor T1 of the first pixel PX1 and the second transistor T2 of the first pixel PX1 may be located on the base substrate SUB1.

Each of the transistors T1 and T2 may include a gate electrode G, the source electrode S, and the drain electrode D.

The first insulating layer INS1 may be located on the base substrate SUB1.

The display device may include the first capacitor C1 and the second capacitor C2 located on the first insulating layer INS1.

The first capacitor C1 may include the first-first capacitor C1-1 and the first-second capacitor C1-2 located on different layers and connected to each other.

The first-first capacitor C1-1 may include the first-first capacitor electrode CPE1-1 and the first-second capacitor electrodes CPE1-2 located on the same layer and overlapping each other in the horizontal direction (for example, the second direction DR2 and/or the first direction DR1). The first-first capacitor C1-1 may have substantially the same structure as that of the first-second capacitor C1-2 of FIGS. 12 and 13 described above.

The first-second capacitor C1-2 may include a third capacitor electrode CPE3 and a fourth capacitor electrode CPE4 located on different layers and overlapping in the vertical direction (for example, the third direction DR3). The first-second capacitor C1-2 may have the same structure as that of the capacitor CPT of FIG. 4 described above.

The second capacitor C2 may include the second-first capacitor electrode CPE2-1 and the second-second capacitor electrode CPE2-2 located on the same layer and overlapping each other in the horizontal direction (for example, the second direction DR2 and/or the first direction DR1). The second capacitor C2 may have substantially the same structure as that of the first-second capacitor C1-2 of FIGS. 12 and 13 described above.

The structures of the first capacitor C1 and the second capacitor C2 will be described in detail.

The first gate connection electrode GCE1, the second-first capacitor electrode CPE2-1, the second-second capacitor electrode CPE2-2, and a first drain connection electrode DCE1 may be located on the first insulating layer INS1.

The first gate connection electrode GCE1 may be connected to the gate electrode G of the first transistor T1 through the contact hole of the first insulating layer INS1.

The second-first capacitor electrode CPE2-1 may be connected to the first drain connection electrode DCE1. For example, the second-first capacitor electrode CPE2-1 and the first drain connection electrode DCE1 may be integrally formed. The second-first capacitor electrode CPE2-1 may be, for example, the second electrode of the second capacitor C2.

The second-second capacitor electrode CPE2-2 may be connected to the first gate connection electrode GCE1. For example, the second-second capacitor electrode CPE2-2 and the first gate connection electrode GCE1 may be integrally formed. The second-second capacitor electrode CPE2-2 may be, for example, the first electrode of the second capacitor C2.

The first drain connection electrode DCE1 may be connected to the drain electrode D of the second transistor T2 through the contact hole of the first insulating layer INS1.

The second insulating layer INS2 may be located on the first gate connection electrode GCE1, the second-first capacitor electrode CPE2-1, the second-second capacitor electrode CPE2-2, and the first drain connection electrode DCE1.

The second gate connection electrode GCE2, the first-first capacitor electrode CPE1-1, the first-second capacitor electrode CPE1-2, and a second drain connection electrode DCE2 may be located on the second insulating layer INS2.

The second gate connection electrode GCE2 may be connected to the first gate connection electrode GCE1 through the contact hole of the second insulating layer INS2.

The first-first capacitor electrode CPE1-1 may be connected to the second drain connection electrode DCE2. For example, the first-first capacitor electrode CPE1-1 and the second drain connection electrode DCE2 may be integrally formed. The first-first capacitor electrode CPE1-1 may be, for example, the second electrode of the first-first capacitor C1-1.

The first-second capacitor electrode CPE1-2 may be connected to the second gate connection electrode GCE2. For example, the first-second capacitor electrode CPE1-2 and the second gate connection electrode GCE2 may be integrally formed. The first-second capacitor electrode CPE1-2 may be, for example, the first electrode of the first-first capacitor C1-1.

The second drain connection electrode DCE2 may be connected to the first drain connection electrode DCE1 through the contact hole of the second insulating layer INS2.

The third insulating layer INS3 may be located on the second gate connection electrode GCE2, the first-first capacitor electrode CPE1-1, the first-second capacitor electrode CPE1-2, and the second drain connection electrode DCE2.

The third gate connection electrode GCE3 and the third capacitor electrode CPE3 may be located on the third insulating layer INS3.

The third gate connection electrode GCE3 may be connected to the second gate connection electrode GCE2 through the contact hole of the third insulating layer INS3.

The third capacitor electrode CPE3 may be, for example, the first electrode of the first-second capacitor C1-2. The third capacitor electrode CPE3 may be connected to the third gate connection electrode GCE3. For example, the third capacitor electrode CPE3 and the third gate connection electrode GCE3 may be integrally formed. The third capacitor electrode CPE3 may have the same shape as that of any one of the first capacitor electrodes CPE1 of FIGS. 2, 3, 4, 6, 7, 8, and 9 described above, for example.

The fourth insulating layer INS4 may be located on the third gate connection electrode GCE3 and the third capacitor electrode CPE3.

The fourth capacitor electrode CPE4 may be located on the fourth insulating layer INS4. The fourth capacitor electrode CPE4 may be located on the fourth insulating layer INS4 to overlap the third capacitor electrode CPE3. The fourth capacitor electrode CPE4 may be, for example, the second electrode of the first-second capacitor C1-2. The fourth capacitor electrode CPE4 may have the same shape as that of any one of the second capacitor electrodes CPE2 of FIGS. 2, 3, 4, 6, 7, 8, and 9 described above, for example. Meanwhile, the fourth capacitor electrode CPE4 may be connected to the driving voltage line VDL. For example, the fourth capacitor electrode CPE4 and the driving voltage line VDL may be integrally formed.

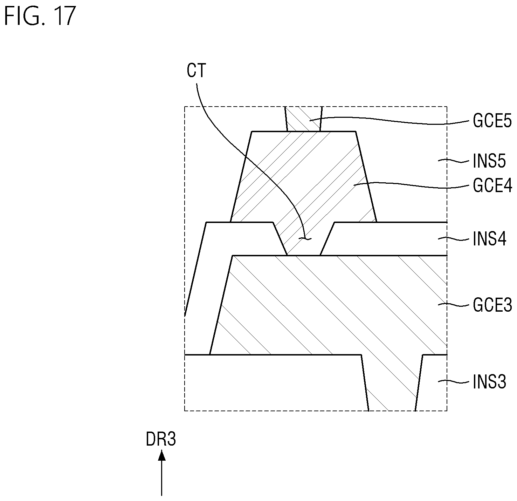

FIG. 17 is an enlarged view of part A of FIG. 14.

As shown in FIG. 17, the third gate connection electrode GCE3 and the fifth gate connection electrode GCE5 may be connected to each other by the fourth gate connection electrode GCE4 located therebetween. In other words, the fourth gate connection electrode GCE4 may function as a bridge electrode connecting the third gate connection electrode GCE3 and the fifth gate connection electrode GCE5 to each other. In addition, the fourth gate connection electrode GCE4 may also serve to reduce or prevent the likelihood of the third gate connection electrode GCE3 being damaged by an etchant during the process of forming the fifth gate connection electrode GCE5. This etchant may permeate the third gate connection electrode GCE3 through the contact hole CT of the fourth insulating layer INS4, for example. However, when the fourth gate connection electrode GCE4 is formed in advance before the formation of the fifth gate connection electrode GCE5, the fourth gate connection electrode GCE4 blocks the contact hole CT of the fourth insulating layer INS4, thereby reducing or preventing the likelihood of the third gate connection electrode GCE3 being exposed to the etchant.

In one or more embodiments, the third gate connection electrode GCE3 and the fifth gate connection electrode GCE5 may be directly connected without the fourth gate connection electrode GCE4.

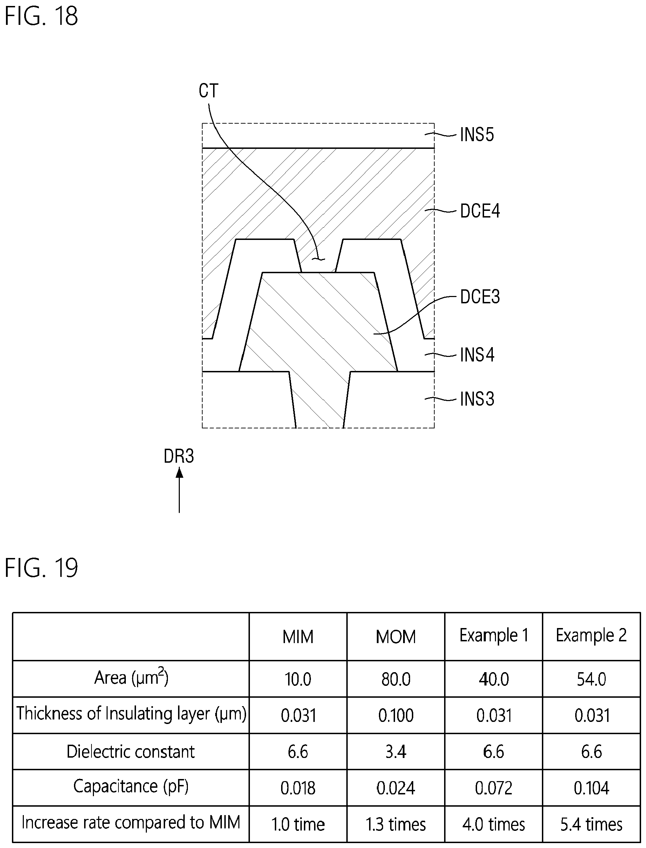

FIG. 18 is an enlarged view of part B of FIG. 14.

As shown in FIG. 18, the third drain connection electrode DCE3 may be connected to the fourth drain connection electrode DCE4 through the contact hole of the fourth insulating layer INS4. In one or more embodiments, the fourth drain connection electrode DCE4 may function as a bridge electrode for connecting the third drain connection electrode DCE3 and another connection electrode (hereinafter, referred to as a fifth connection electrode) to each other. In addition, the fourth drain connection electrode DCE4 may also serve to reduce or prevent the likelihood of the third drain connection electrode DCE3 being damaged by the etchant during the process of forming the fifth connection electrode.

FIG. 19 is a diagram illustrating effects of a display device according to one or more embodiments.

In FIG. 19, MIM may refer to a Metal-Insulator-Metal capacitor, MOM may refer to a Metal-Oxide-Metal capacitor, Example 1 may refer to the capacitor CPT of FIG. 2 described above, and Example 2 may refer to the capacitor CPT of FIG. 5.

Further, in FIG. 19, the area may refer to the area of facing surfaces of the first capacitor electrode and the second capacitor electrode of each capacitor located in an area of the same size (for example, one emission area).

Further, in FIG. 19, the thickness of the insulating layer may refer to the thickness of the insulating layer between the first capacitor electrode and the second capacitor electrode of each capacitor, the dielectric constant may mean the dielectric constant of the aforementioned insulating layer, and the capacitance may mean the capacitance of each capacitor.

As shown in FIG. 19, among the MIM, the MOM, Example 1, and Example 2, the MOM may have the largest area. Because, however, the MOM has a large insulating layer due to its characteristics, the capacitors CPT of Example 1 and Example 2 may have larger capacitances than that of the MIM capacitor. For example, in an area of the same size, the capacitance of the capacitor CPT of Example 1 may be about 4 times that of the MIM capacitor, and the capacitance of the capacitor CPT of Example 2 may be about 5.4 times that of the MIM capacitor. Therefore, the capacitor of the display device according to one or more embodiments may have a larger capacitance in an area of the same size. Accordingly, the characteristics of the pixel circuit may be stably secured. Further, it is possible to manufacture a capacitor having a larger capacitance with a smaller number of metal layers.

In concluding the detailed description, those skilled in the art will appreciate that many variations and modifications can be made to the preferred embodiments without substantially departing from the aspects of the present disclosure. Therefore, the disclosed embodiments are used in a generic and descriptive sense only and not for purposes of limitation. Further Embodiments are set out in the following clauses:
Clause 1. A display device comprising:
   a first data line;
   a first pixel connected to the first data line, and comprising a driving transistor; and
   a first capacitor between a gate electrode of the driving transistor and the first data line.
Clause 2. The display device of Clause 1, wherein the first capacitor overlaps the first data line and the gate electrode.
Clause 3. The display device of Clause 1 or Clause 2, further comprising:
   a second data line adjacent to the first data line; and
   a second pixel connected to the second data line.
Clause 4. The display device of Clause 3, wherein the first capacitor is between the first data line and the gate electrode, and between the second data line and the gate electrode.
Clause 5. The display device of Clause 3 or Clause 4, wherein the second data line is more distant from the gate electrode than the first data line.
Clause 6. The display device of any one of Clauses 3-5, wherein the first pixel and the second pixel are between the first data line and the second data line.
Clause 7. The display device of any one of Clauses 3 - 6, wherein the first pixel and the second pixel are configured to provide light of a same color.
Clause 8. The display device of any preceding Clause, wherein the first capacitor comprises:
   a first capacitor electrode comprising electrodes spaced apart from each other to have a gap;
   an insulating layer above the first capacitor electrode; and
   a second capacitor electrode above the insulating layer, and overlapping the gap and the electrodes of the first capacitor electrode.
Clause 9. The display device of Clause 8, wherein at least a part of the second capacitor electrode is between adjacent electrodes.
Clause 10. The display device of Clause 8 or Clause 9, wherein the second capacitor electrode overlaps an entirety of the first capacitor electrode.
Clause 11. The display device of any one of Clauses 8 -10, wherein an end of the second capacitor electrode extends further in one direction than an end of the first capacitor electrode.
Clause 12. The display device of any one of Clauses 1 - 7, wherein the first capacitor comprises:
   a first insulating layer comprising layers having stepped portions of different respective sizes;
   a first capacitor electrode above the first insulating layer, and having stepped portions corresponding to the stepped portions of the first insulating layer;
   a second insulating layer above the first capacitor electrode, and having stepped portions corresponding to the stepped portions of the first capacitor electrode; and
   a second capacitor electrode above the second insulating layer, and having stepped portions corresponding to the stepped portions of the second insulating layer.
Clause 13. The display device of Clause 12, wherein the first capacitor electrode has a larger number of layers than the first insulating layer.
Clause 14. The display device of any one of Clauses 8 - 13, wherein the first capacitor electrode comprises:
   a first electrode extending in a first direction; and
   second electrodes extending from the first electrode in a second direction crossing the first direction, adjacent ones of the second electrodes being spaced apart such that a gap exists therebetween.
Clause 15. The display device of any one of Clauses 8 - 13, wherein the first capacitor electrode comprises:
   a first electrode having a closed curve shape; and
   second electrodes inside the first electrode in plan view, and extending in one direction from the first electrode, adjacent ones of the second electrodes being spaced apart such that a gap exists therebetween.
Clause 16. The display device of any one of Clauses 8 - 13, wherein the first capacitor electrode comprises:
   a first electrode having a closed curve shape; and
   second electrodes inside the first electrode in plan view, and respectively extending from the first electrode in a first direction and a second direction,
   wherein the second electrodes in the first direction and the second electrodes in the second direction substantially perpendicularly intersect each other, and
   wherein adjacent ones of the second electrodes are spaced apart such that a gap exists therebetween.
Clause 17. The display device of any one of Clauses 8 -13, wherein the first capacitor electrode comprises:
   a first electrode having a closed curve shape; and
   second electrodes inside the first electrode in plan view, and respectively extending in a first oblique direction and in a second oblique direction from the first electrode,
   wherein the second electrodes in the first oblique direction and the second electrodes in the second oblique direction substantially perpendicularly intersect each other, and
   wherein adjacent ones of the second electrodes are spaced apart such that a gap exists therebetween.
Clause 18. The display device of any one of Clauses 8 - 13, wherein the first capacitor electrode comprises first electrodes and second electrodes having a spiral structure extending outwardly while rotating in a counterclockwise direction from a central portion,
   wherein adjacent ones of the first electrodes are spaced apart such that a gap exists therebetween, and
   wherein adjacent ones of the second electrodes are spaced apart such that a gap exists therebetween.
Clause 19. The display device of any preceding Clause 1, further comprising a second capacitor above the first capacitor.
Clause 20. The display device of Clause 19, wherein the second capacitor is at a same layer as the first data line.
Clause 21. The display device of Clause 19 or Clause 20, wherein the second capacitor comprises:
   a first capacitor electrode; and
   a second capacitor electrode adjacent to the first capacitor electrode, and at a same layer as the first capacitor electrode.
Clause 22. The display device of Clause 21, wherein the first capacitor comprises a first capacitor electrode and a second capacitor electrode opposite each other on different layers, and wherein a taper angle of the first capacitor electrode in the first capacitor is smaller than a taper angle of the first capacitor electrode in the second capacitor.
Clause 23. The display device of any one of Clauses 8 - 22, further comprising:
   a first connection electrode connected to the first capacitor electrode;
   a second connection electrode above the first connection electrode; and
   a third connection electrode connecting the first connection electrode to the second connection electrode, and between the first connection electrode and the second connection electrode.
Clause 24. A display device comprising:
   a substrate;
   a transistor above the substrate;
   a first data line above the transistor; and
   a capacitor between a gate electrode of the transistor and the first data line.
Clause 25. The display device of Clause 24, wherein the capacitor overlaps the first data line and the gate electrode.
Clause 26. The display device of Clause 25, further comprising a second data line adjacent to the first data line.
Clause 27. The display device of Clause 26, wherein the capacitor is between the first data line and the gate electrode, and between the second data line and the gate electrode.
Clause 28. The display device of Clause 26, wherein the second data line is more distant from the gate electrode than the first data line.
Clause 29. The display device of Clause 24, wherein the capacitor comprises:
   a first capacitor electrode comprising electrodes spaced apart to have a gap therebetween;
   an insulating layer above the first capacitor electrode; and
   a second capacitor electrode above the insulating layer to overlap the gap and the electrodes of the first capacitor electrode.
Clause 30. The display device of Clause 29, wherein at least a part of the second capacitor electrode is between adjacent ones of the electrodes.

## Claims

1. A display device comprising:
a first data line;
a first pixel connected to the first data line, and comprising a driving transistor; and
a first capacitor between a gate electrode of the driving transistor and the first data line.

2. The display device of claim 1, wherein the first capacitor overlaps the first data line and the gate electrode.

3. The display device of claim 1 or claim 2, further comprising:
a second data line adjacent to the first data line; and
a second pixel connected to the second data line.

4. The display device of claim 3, wherein the first capacitor is between the first data line and the gate electrode, and between the second data line and the gate electrode.

5. The display device of claim 3 or claim 4, wherein the second data line is more distant from the gate electrode than the first data line; and/or wherein the first pixel and the second pixel are between the first data line and the second data line.

6. The display device of any one of claims 3-5, wherein the first pixel and the second pixel are configured to provide light of a same color.

7. The display device of any preceding claim, wherein the first capacitor comprises:
a first capacitor electrode comprising electrodes spaced apart from each other to have a gap;
an insulating layer above the first capacitor electrode; and
a second capacitor electrode above the insulating layer, and overlapping the gap and the electrodes of the first capacitor electrode.

8. The display device of claim 7, wherein at least a part of the second capacitor electrode is between adjacent electrodes of the first capacitor electrode.

9. The display device of claim 7 or claim 8, wherein the second capacitor electrode overlaps an entirety of the first capacitor electrode; and/or wherein an end of the second capacitor electrode extends further in one direction than an end of the first capacitor electrode.

10. The display device of any one of claims 1 - 6, wherein the first capacitor comprises:
a first insulating layer comprising layers having stepped portions of different respective sizes;
a first capacitor electrode above the first insulating layer, and having stepped portions corresponding to the stepped portions of the first insulating layer;
a second insulating layer above the first capacitor electrode, and having stepped portions corresponding to the stepped portions of the first capacitor electrode; and
a second capacitor electrode above the second insulating layer, and having stepped portions corresponding to the stepped portions of the second insulating layer wherein, optionally, the first capacitor electrode has a larger number of layers than the first insulating layer.

11. The display device of any one of claims 7 - 10, wherein the first capacitor electrode comprises:
a first electrode extending in a first direction; and
second electrodes extending from the first electrode in a second direction crossing the first direction, adjacent ones of the second electrodes being spaced apart such that a gap exists therebetween.

12. The display device of any one of claims 7 - 10, wherein the first capacitor electrode comprises:
a first electrode having a closed curve shape; and
second electrodes inside the first electrode in plan view, and extending in one direction from the first electrode, adjacent ones of the second electrodes being spaced apart such that a gap exists therebetween.

13. The display device of any one of claims 7 - 10, wherein the first capacitor electrode comprises:
a first electrode having a closed curve shape; and
second electrodes inside the first electrode in plan view, and respectively extending from the first electrode in a first direction and a second direction,
wherein the second electrodes in the first direction and the second electrodes in the second direction substantially perpendicularly intersect each other, and
wherein adjacent ones of the second electrodes are spaced apart such that a gap exists therebetween.

14. The display device of any one of claims 7 - 10, wherein the first capacitor electrode comprises:
a first electrode having a closed curve shape; and
second electrodes inside the first electrode in plan view, and respectively extending in a first oblique direction and in a second oblique direction from the first electrode,
wherein the second electrodes in the first oblique direction and the second electrodes in the second oblique direction substantially perpendicularly intersect each other, and
wherein adjacent ones of the second electrodes are spaced apart such that a gap exists therebetween.

15. The display device of any one of claims 7 - 10, wherein the first capacitor electrode comprises first electrodes and second electrodes having a spiral structure extending outwardly while rotating in a counterclockwise direction from a central portion,
wherein adjacent ones of the first electrodes are spaced apart such that a gap exists therebetween, and
wherein adjacent ones of the second electrodes are spaced apart such that a gap exists therebetween.

16. The display device of any preceding claim, further comprising a second capacitor above the first capacitor, wherein, optionally, the second capacitor is at a same layer as the first data line.

17. The display device of claim 16, wherein the second capacitor comprises:
a first capacitor electrode; and
a second capacitor electrode adjacent to the first capacitor electrode, and at a same layer as the first capacitor electrode;
wherein, optionally, the first capacitor comprises a first capacitor electrode and a second capacitor electrode opposite each other on different layers, and wherein a taper angle of the first capacitor electrode in the first capacitor is smaller than a taper angle of the first capacitor electrode in the second capacitor.

18. The display device of any one of claims 7 - 17, further comprising:
a first connection electrode connected to the first capacitor electrode;
a second connection electrode above the first connection electrode; and
a third connection electrode connecting the first connection electrode to the second connection electrode, and between the first connection electrode and the second connection electrode.

19. A display device according to any preceding claim, further comprising:
a substrate;
wherein the driving transistor is above the substrate; and
the first data line is above the transistor.
